# EUROPEAN PATENT SPECIFICATION

(11) **EP 1 942 150 B1**
(45) Date of publication and mention of the grant of the patent: **22.08.2018**
(21) Application number: 06811265.5
(22) Date of filing: 05.10.2006
(51) Int. Cl.: C08L 83/04, C08G 77/06, C08K 5/05, C09D 183/04, G02B 1/04, G02B 3/00, G03F 7/075

(54) **SILOXANE RESIN COMPOSITION AND METHOD FOR PRODUCING SAME**
SILOXANHARZZUSAMMENSETZUNG UND HERSTELLUNGSVERFAHREN DAFÜR
COMPOSITION DE RESINE DE SILOXANE ET SON PROCEDE DE PRODUCTION

(30) Priority: 28.10.2005 JP 2005313916
(43) Date of publication of application: 09.07.2008
(73) Proprietor: TORAY INDUSTRIES, INC., Tokyo 103-8666 (JP)
(72) Inventor: NIWA, Hiroyuki, Otsu-shi, Shiga 5208558 (JP); HOSONO, Hiroshi, Otsu-shi, Shiga 5208558 (JP); SUWA, Mitsuhito, Otsu-shi, Shiga 5208558 (JP)
(74) Representative: Hoefer & Partner Patentanwälte mbB
(86) International application number: PCT/JP2006/319927
(87) International publication number: WO 2007/049440

(56) References cited:
- WO-A1-2004/009505
- JP-A- 10 133 370
- JP-A- 10 219 235
- JP-A- 10 282 325
- JP-A- 2001 294 811
- JP-A- 2004 312 004
- JP-A- 2006 178 436
- JP-A- 2006 276 598
- JP-A- 2006 293 337
- US-A- 5 531 814
- US-A1- 2002 099 161

## Description

### [Technical field]

The present invention relates to a siloxane resin composition, a production method thereof and an optical article using the same. The siloxane resin composition and the optical article of this invention can be suitably used as optical lenses such as microlens arrays of solid imaging devices, a planarization film for TFTs (thin film transistors) of liquid crystal displays and organic EL (electroluminescence) displays, or as a reflection prevention film, reflection prevention film, reflection prevention sheet or optical filter.

### [Background art]

Solid imaging devices such as CCD (charge coupled device) image sensors and CMOS (complementary metal-oxide semiconductor) image sensors, display substrates, various reflection prevention films, etc. use various coating materials such as various lens materials and planarization films. These coating materials are required to have optical properties such as transparency and appropriate refractive index and many other properties such as heat resistance and photolithographic processability. Siloxane compound-containing resin compositions are known to suitably respond to these requirements (for example, see Patent Document 1).

The coating materials used in these applications are often applied to ground surfaces and substrates having large and small level differences. For this reason, it is necessary that the coating materials can perfectly cover the level differences of substrates without causing coating irregularity, in addition to having the aforesaid properties. However, the conventional siloxane compound-containing resin compositions are likely to cause coating irregularity for such reasons that substrates have level differences and that the resin compositions are insufficient in the capability to wet the substrates and in the capability to cover the level differences of substrates.

Especially it is preferred that the planarization films for microlenses of solid imaging devices have a property of being able to form flat films on the microlenses with large concavities and convexities and a property of being low in refractive index for allowing the condensation efficiency of microlenses to be enhanced. However, no good planarization film satisfactory in both the properties is known.
[Patent Document 1] JP2001-81040A
WO 2004/009505A1 discloses a treated article including a substrate and a hydrophobic film coated to the surface of the substrate. The film is obtainable from a hydrophobic surface treatment composition comprising a mixture or reaction product of a silicone fluid and a solvent. The silicone fluid is an alkyl silane or a polysiloxane having a functional group capable of a condensation reaction with hydroxyl. The hydrophobic surface treatment composition is substantially free of an external curing agent. The hydrophobic surface treatment composition may contain a cosolvent or catalyst. A method of manufacturing the treated article is also disclosed.

### [Disclosure of the invention]

### [Problem to be solved by the invention]

The object of this invention is to provide a siloxane resin composition capable of being applied to a substrate with level differences without coating irregularity and capable of excellently covering the level differences of the substrate.

### [Means for solving the problem]

The present invention is defined in the appended claims.

This invention provides a siloxane resin composition comprising a siloxane compound and 1-t-butoxy-2-propanol and metal compound particles, wherein the siloxane resin composition further comprises a quinonediazide-based photosensitive agent and is positive photosensitive or a photo acid generating agent and is negative photosensitive.

Further, this invention provides an optical article with a cured film obtained by curing said siloxane resin composition.

Furthermore, this invention provides a method for producing the siloxane resin composition comprising the step of condensing the hydrolysis product of an alkoxysilane compound by reaction in the presence of 1-t-butoxy-2-propanol to obtain the siloxane compound.

### [Effect of the invention]

The siloxane resin composition of this invention can be applied onto a substrate with level differences without causing coating irregularity and can excellently cover the level differences of the substrate, since it contains 1-t-butoxy-2-propanol. The cured film obtained by curing the siloxane resin composition of this invention can be suitably used as optical lenses such as microlenses of solid imaging devices, a planarization film for TFTs of liquid crystal displays and organic EL displays, or as a hard coating layer for reflection prevention films or reflection prevention films, or as an optical filter material.

### [Brief description of the drawings]

[Fig. 1] is a cross sectional view of a substrate generally showing how to evaluate the capability of a coating film to cover level differences.
[Figs. 2] are drawings showing a substrate used for evaluating coating irregularity.
[Figs. 3] are optical microscope images showing substrates for evaluating coating irregularity.

### [Meanings of symbols]

1 ... polyimide pattern (with a height of 0.7 µm)
2 ... coating film
3 ... silicon substrate
a ... Measuring point at a distance of 10 µm from an end of a polyimide pattern
b ... Measuring point at a distance of 100 µm from an end of a polyimide pattern
c ... Measuring point at a distance of 500 µm from an end of a polyimide pattern
d ... Measuring point in a portion free from a level difference at a distance of 5 mm or more from an end of a polyimide pattern

### [The best modes for carrying out the invention]

This invention is explained below particularly.

The siloxane resin composition of this invention comprises the siloxane compound described later and 1-t-butoxy-2-propanol. The 1-t-butoxy-2-propanol contained allows a film free from coating irregularity to be obtained and assures a good capability to cover the level differences of the substrate.

It is preferred that the siloxane compound used in the siloxane resin composition of this invention is a siloxane compound obtained by hydrolyzing an alkoxysilane compound, to form a silanol compound and condensing the silanol compound by reaction. It is preferred that the alkoxysilane compound is at least one or more selected from the alkoxysilane compounds represented by any of the following general formulae (1) through (3).

R¹SI(OR⁴)₃ (1)

R¹ denotes a hydrogen atom, alkyl group, alkenyl group, aryl group or any of the substitution products thereof. It is preferred that the number of carbon atoms of R¹ is in a range from 1 to 20. As the R¹, an appropriate one can be selected to suit each application of the cured film. For example, in view of crack resistance of the cured film, it is preferred to use an alkoxysilane compound with a phenyl group as R¹. Further, in the case where it is desired to obtain a cured film with a low refractive index, it is preferred to use an alkoxysilane compound a methyl group or an alkyl group containing fluorine atoms as R¹. Each R⁴ denotes a methyl group, ethyl group, propyl group, isopropyl group or butyl group, and the plural R⁴s can be identical with or different from each other. As the R⁴, a methyl group or ethyl group is preferred in view of easiness of hydrolysis reaction and availability of raw materials.

R²R³Si(OR⁵)₂ (2)

R² and R³ denote, respectively, a hydrogen atom, alkyl group, alkenyl group, aryl group or any of the substitution products thereof and they can be identical without or different from each other. It is preferred that the number of carbon atoms of R² and R³ is in a range from 1 to 20. Each R⁵ denotes a methyl group, ethyl group, propyl group, isopropyl group or butyl group, and the plural R⁵s can be identical with or different from each other. As the R⁵, a methyl group or ethyl group is preferred in view of easiness of hydrolysis reaction and availability of raw materials.

Si(OR⁶)₄ (3)

each R⁶ denotes a methyl group, ethyl group, propyl group, isopropyl group or butyl group, and the plural R⁶s can be identical with or different from each other. As the R⁶, a methyl group or ethyl group is preferred in view of easiness of hydrolysis reaction and availability of raw materials.

Any one of the alkoxysilane compounds represented by these general formulae (1) through (3) can be used alone or two or more of them can also be used in combination.

Examples of the alkoxysilane compounds represented by the general formulae (1) through (3) are enumerated below.

Examples of the trifunctional silane compound represented by the general formula (1) include methyltrimethoxysilane, methyltriethoxysilane, methyltriethoxysilane, methyltripropoxysilane, methyltriisopropoxysilane, methyltributoxysilane, ethyltrimethoxysilane, ethyltriethoxysilane, hexyltrimethoxysilane, octadecyltrimethoxysilane, octadecyltriethoxysilane, phenyltrimethoxysilane, phenyltriethoxysilane, phenyltriisopropoxysilane, 3-aminopropyltriethoxysilane, N-(2-aminoethyl)-3-aminopropyltrimethoxysilane, 3-chloropropyltrimethoxysilane, 3-(N,N-diglycidyl)aminopropyltrimethoxysilane, 3-glycidoxypropyltrimethoxysilane, vinyltrimethoxysilane, vinyltriethoxysilane, γ-methacryloxypropyltrimethoxysilane, γ-methacryloxypropyltriethoxysilane, γ-aminopropyltrimethoxysilane, γ-aminopropyltriethoxysilane, N-β-(aminoethyl)-γ-aminopropyltrimethoxysilane, β-cyanoethyltriethoxysilane, glycidoxymethyltrimethoxysilane, glycidoxymethyltriethoxysilane, α-glycidoxyethyltrimethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltriisopropoxysilane, γ-glycidoxypropyltributoxysilane, γ-glycidoxypropyltrimethoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane (3,4-epoxycyclohexyl)methyltrimethoxysilane, (3,4-epoxycyclohexyl)methyltriethoxysilane, (3,4-epoxycyclohexyl)methyltrimethoxysilane, (3,4-epoxycyclohexyl)methyltriethoxysilane, 2-(3,4-epoxycyclohexyl)ethyltripropoxysilane, 2-(3,4-epoxycyclohexyl)ethyltributoxysilane, 2-(3,4-epoxycyclohexyl)ethyltrimethoxysilane, 2-(3,4-epoxycyclohexyl)ethyltriethoxysilane, 3-(3,4-epoxycyclohexyl)propyltrimethoxysilane, 3-(3,4-epoxycyclohexyl)propyltriethoxysilane, 4-(3,4-epoxycyclohexyl)butyltrimethoxysilane, 4-(3,4-epoxycyclohexyl)butyltriethoxysilane, trifluoromethyltrimethoxysilane, trifluoromethyltriethoxysilane, trifluoropropyltrimethoxysilane, trifluoropropyltriethoxysilane, perfluoropropyltrimethoxysilane, perfluoropropyltriethoxysilane, perfluoropentyltrimethoxysilane, perfluoropentyltriethoxysilane, tridecafluorooctyltrimethoxysilane, tridecafluorooctyltriethoxysilane, tridecafluorooctyltripropoxysilane, tridecafluorooctyltriisopropoxysilane, heptadecafluorodecyltrimethoxysilane, heptadecafluorodecyltriethoxysilane.

Examples of the bifunctional silane compound represented by the general formula (2) include dimethyldimethoxysilane, dimethyldiethoxysilane, diphenyldimethoxysilane, diphenyldiethoxysilane, methylphenyldimethoxysilane, methylvinyldimethoxysilane, methylvinyldiethoxysilane, γ-glycidoxypropylmethyldimethoxysilane, γ-aminopropylmethyldimethoxysilane, γ-aminopropylmethyldiethoxysilane, N-(2-aminoethyl)-3-aminopropylmethyldimethoxysilane, γ-methacryloxypropylmethyldimethoxysilane, γ-methacryloxypropylmethyldiethoxysilane, glycidoxymethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylmethyldiethoxysilane, α-glycidoxypropylmethyldimethoxysilane, α-glycidoxypropylmethyldiethoxysilane, β-glycidoxypropylmethyldimethoxysilane, β-glycidoxypropylmethyldiethoxysilane, γ-glycidoxypropylmethyldimethoxysilane, γ-glycidoxypropylmethyldiethoxysilane, γ-glycidoxypropylmethyldipropoxysilane, β-glycidoxypropylmethyldibutoxysilane, γ-glycidoxypropylmethyldimethoxyethoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, trifluoropropylmethyldimethoxysilane, trifluoropropylmethyldiethoxysilane, trifluoropropylethyldimethoxysilane, trifluoropropylethyldiethoxysilane, trifluoropropylvinyldimethoxysilane, trifluoropropylvinyldiethoxysilane, heptadecafluorodecylmethyldimethoxysilane, 3-chloropropylmethyldimethoxysilane, 3-chloropropylmethyldiethoxysilane, cyclohexylmethyldimethoxysilane, 3-methacryloxypropyldimethoxysilane, octadecylmethyldimethoxysilane, etc. Among them, for the purpose of making the obtained coating film flexible, dimethyldialkoxysilane can be preferably used.

Examples of the tetrafunctional silane compound represented by the general formula (3) include tetramethoxysilane, tetraethoxysilane, etc.

For lowering the refractive index of the siloxane resin composition of this invention or for making the siloxane resin composition water-repellent, it is preferred to use an alkoxysiloxane compound containing an organic group with fluorine atoms. Examples of the organic group with fluorine atoms include a trifluoromethyl group, trifluoropropyl group, perfluoropropyl group, perfluoropentyl group, tridecafluorooctyl group, etc. If the fluorine atom content is increased, a film with a low refractive index can be obtained. So, it is preferred to let the siloxane resin composition contain 10 wt% or more of fluorine atoms based on the total solid content of the siloxane resin composition. More preferred is 15 wt% or more. As planarization films for on-chip microlens patterns of solid imaging devices, it is preferred to use a material with a low refractive index in view of higher condensation efficiency of microlenses. For this reason, for this application, it is preferred to use an alkoxysilane compound containing an organic group with fluorine atoms and not containing any aromatic ring.

The amount of the siloxane compound contained in the siloxane resin composition of this invention can be selected as desired to suit each desired film thickness and application. In general, the amount is 0.1 to 80 wt%.

For forming a cured siloxane film, it is preferred that the siloxane resin composition of this invention contains 10 wt% or more of a siloxane compound based on the total solid content. More preferred is 20 wt% or more.

The siloxane resin composition of this invention contains a metal compound for control of refractive index, crack resistance and higher elastic modulus. The metal compound is metal compound particles. As the metal compound particles, those with a number average particle size of 1 nm to 200 nm are preferred. For obtaining a cured film with a high transparency, it is preferred that the number average particle size is 1 nm to 70 nm. The average particle size of the metal compound particles can be measured by a gas adsorption method, dynamic light scattering method, X-ray small angle scattering method or a method of directly measuring the particle size using a transmission electron microscope or scanning electron microscope, etc. The number average particle size of this invention refers to the value measured by a dynamic light scattering method.

Examples of the metal compound particles include silicon compound particles, aluminum compound particles, tin compound particles, titanium compound particles, zirconium compound particles, etc., and appropriate particles can be selected for each application. For example, for obtaining a cured film with a high refractive index, titanium compound particles such as titanium oxide particles and zirconium compound particles such as zirconium oxide particles can be preferably used. Further, for obtaining a cured film with a low refractive index, hollow silica particles, etc. can be preferably used.

Examples of commercially available metal compound particles include tin oxide-titanium oxide composite particles such as "Optlake TR-502" and "Optlake TR-504, " silicon oxide-titanium oxide composite particles such as "Optlake TR-503," "Optlake TR-520" and "Optlake TR-513, " titanium oxide particles such as "Optlake TR-505" (respectively trade names, produced by Catalysts & Chemicals Industries Co., Ltd.), zirconium oxide particles (produced by Kojundo Chemical Laboratory Co., Ltd.), tin oxide-zirconium oxide composite particles (produced by Catalysts & Chemicals Industries Co., Ltd.), tin oxide particles (produced by Kojundo Chemical Laboratory Co., Ltd.), etc.

The content of metal compound particles is not especially limited, and any appropriate amount suitable for each application can be used. In general, the content of metal compound particles is about 1 to about 70 wt% based on the total solid content of the siloxane resin composition.

The siloxane resin composition of this invention can be obtained, for example, by hydrolyzing an alkoxysilane compound and condensing the hydrolysis product by reaction in the presence of 1-t-butoxy-2-propanol. As another method, an alkoxysilane compound can be hydrolyzed in the presence or absence of a solvent other than 1-t-butoxy-2-propanol, and the hydrolysis product can be condensed by reaction, followed by adding 1-t-butoxy-2-propanol to the condensation product.

It is preferred that the hydrolysis reaction is performed by adding an acid catalyst and water in a solvent, taking 1 to 180 minutes, and carrying out the reaction at room temperature to 110°C for 1 to 180 minutes. The hydrolysis reaction under these conditions can inhibit a sudden reaction. A more preferred reaction temperature range is 40 to 105°C. As the solvent of the hydrolysis reaction, 1-t-butoxy-2-propanol can also be used.

It is preferred that the hydrolysis reaction is performed in the presence of an acid catalyst. The acid catalyst can be an acid catalyst of hydrochloric acid, acetic acid, formic acid, nitric acid, oxalic acid, hydrochloric acid, sulfuric acid, phosphoric acid, polyphosphoric acid, polycarboxylic acid or any of the anhydrides thereof, or ion exchange resin, etc. Especially an acid aqueous solution containing formic acid, acetic acid or phosphoric acid is preferred. It is preferred that the content of the acid catalyst is 0.05 part by weight or more per 100 parts by weight of the entire alkoxysilane compound used in the hydrolysis reaction. A more preferred amount is 0.1 part by weight or more. On the other hand, a preferred amount is 10 parts by weight or less, and a more preferred amount is 5 parts by weight or less. If the hydrolysis reaction is performed using said range of an acid catalyst, the reaction can be easily controlled.

After a silanol compound is obtained by the hydrolysis reaction of an alkoxysilane compound, it is preferred that the reaction solution is heated at 50°C to lower than the boiling point of the solvent for 1 to 100 hours to perform a condensation reaction without taking out the silanol compound. Further, the polymerization degree of the siloxane compound can also be enhanced by reheating or adding a base catalyst.

The respective conditions for hydrolysis can be decided considering the reaction scale, the size and shape of the reaction vessel, etc. For example, by setting the acid concentration, reaction temperature, reaction time, etc. in appropriate ranges, physical properties suitable for the intended application can be obtained.

The solvent used for the hydrolysis reaction of the alkoxysilane compound and for the condensation reaction of the hydrolysis product is not especially limited, and the reactions can also be performed without any solvent. However, it is preferred to select the solvent, considering the stability, wettability, volatility, etc. of the siloxane resin composition. Two or more solvents can also be used. Examples of the solvent include alcohols such as methanol, ethanol, propanol, isopropanol, butanol, isobutanol, t-butanol, pentanol, 4-methyl-2-pentanol, 3-methyl-2-butanol, 3-methyl-3-methoxy-1-butanol, 1-t-butoxy-2-propanol and diacetone alcohol; glycols such as ethylene glycol and propylene glycol; ethers such as ethylene glycol monomethyl ether, ethylene glycol monoethyl ether, propylene glycol monomethyl ether, propylene glycol monoethyl ether, propylene glycol monopropyl ether, propylene glycol monobutyl ether, ethylene glycol dimethyl ether, ethylene glycol diethyl ether, ethylene glycol dibutyl ether and diethyl ether; ketones such as methyl ethyl ketone, acetylacetone, methyl propyl ketone, methyl butyl ketone, methyl isobutyl ketone, diisobutyl ketone, cyclopentanone and 2-heptanone; amides such as dimethylformamide and dimethylacetamide; acetates such as ethyl acetate, propyl acetate, butyl acetate, isobutyl acetate, ethylene glycol monoethyl ether acetate, propylene glycol monomethyl ether acetate, 3-methoxybutyl acetate, 3-methyl-3-methoxybutyl acetate, methyl lactate, ethyl lactate and butyl lactate; aromatic or aliphatic hydrocarbons such as toluene, xylene, hexane and cyclohexane, γ-butyrolactone, N-methyl-2-pyrrolidone, dimethyl sulfoxide, etc. In this invention, it is more preferred to use 1-t-butoxy-2-propanol as the solvent for the hydrolysis reaction and the condensation reaction. Further, a mixed solvent consisting of 1-t-butoxy-2-propanol and another solvent can also be used. In view of the transparency, crack resistance, etc. of the cured film, propylene glycol monomethyl ether, propylene glycol monomethyl ether acetate, propylene glycol monoethyl ether, propylene glycol monopropyl ether, propylene glycol monobutyl ether, γ-butyrolactone, etc. can also be preferably used.

In the case where the hydrolysis reaction produces a solvent, the hydrolysis can be performed without any solvent. It is also preferred to add a solvent further after completion of reaction, for adjusting the concentration of the resin composition to a proper level. Furthermore, an adequate amount of a produced alcohol or the like can be distilled away with heating and/or under reduced pressure after completion of hydrolysis, and subsequently a suitable solvent can also be added.

It is preferred that the amount of the solvent used for the hydrolysis reaction is 50 parts by weight or more per 100 parts by weight of the entire alkoxysilane compound. A more preferred amount is 80 parts by weight or more. On the other hand, it is preferred that the upper limit is 1000 parts by weight or less, and a more preferred upper limit is 500 parts by weight or less. If the amount of the solvent is kept in said range, the reaction can be easily controlled, and a resin soluble in the solvent can be easily obtained.

Further, it is preferred that the water used for the hydrolysis reaction is ion exchange water. The amount of water can be selected as desired, but it is preferred that the amount is in a range from 1.0 to 4.0 moles per 1 mole of the alkoxysilane compound.

The siloxane resin composition of this invention may contain any of various curing agents for promoting or facilitating the curing of the resin composition. Examples of the curing agent include nitrogen-containing organic substances, silicone resin curing agents, various metal alcoholates, various metal chelate compounds, isocyanate compounds and polymers thereof, melamine resins, polyfunctional acrylic resins, urea resins, etc. Any one of them can be contained, or two or more of them can also be contained together. Among them, in view of the stability of the curing agent, the processability of the obtained coating film, etc., a metal chelate compound can be preferably used.

Examples of the metal chelate compound include titanium chelate compounds, zirconium chelate compounds, aluminum chelate compounds and magnesium chelate compounds. Any of these metal chelate compounds can be easily obtained by letting a chelating agent react with a metal alkoxide. Examples of the chelating agent include β-diketones such as acetylacetone, benzoylacetone and dibenzoylmethane, and β-keto-acid esters such as ethyl acetoacetate and ethyl benzoylacetate. Preferred examples of the metal chelate compound include aluminum chelate compounds such as ethyl acetoacetate aluminum diisopropylate, aluminum tris(ethyl acetoacetate), alkyl acetoacetate aluminum diisopropylate, aluminum monoacetylacetate bis(ethyl acetoacetate) and aluminum tris (acetylacetonate) and magnesium chelate compounds such as ethyl acetoacetate magnesium monoisopropylate, magnesium bis(ethyl acetoacetate), alkyl acetoacetate magnesium monosopropylate and magnesium bis(acetylacetonate).

It is preferred that the content of the curing agent is 0.1 part by weight or more per 100 parts by weight of the entire siloxane compound in the siloxane resin composition. A more preferred content is 0. 5 part by weight or more. On the other hand, a preferred content is 10 parts by weight or less, and a more preferred content is 6 parts by weight or less. In this specification, the amount of the entire siloxane compound refers to the total amount of the alkoxysilane compound, the hydrolysis product thereof and the condensation product thereof.

Further, it is also preferred that the siloxane resin composition contains a curing catalyst such as a thermal acid generating agent, since the curing of the siloxane compound can be promoted by an acid. The thermal acid generating agent can be selected from various onium salt-based compounds such as sulfonium salts, aromatic diazonium salts, diaryl iodonium salts, triaryl sulfonium salts and triaryl selenium salts, sulfonic acid esters, halogen-containing compounds.

Examples of the sulfonium salts include 4-hydroxyphenyldimethylsulfonium triflate (experimental product "W" produced by Sanshin Chemical Industry Co., Ltd.), benzyl-4-hydroxyphenylmethylsulfonium triflate (experimental product "O" produced by Sanshin Chemical Industry Co., Ltd.), 2-methylbenzyl-4-hydroxyphenylmethylsulfonium triflate (experimental product "N" produced by Sanshin Chemical Industry Co., Ltd.), 4-methylbenzyl-4-hydroxyphenylmethylsulfonium triflate, 4-hydroxyphenylmethyl-1-naphthylmethylsulfonium triflate, 4-methoxycarbonyloxyphenyldimethylsulfonium triflate (experimental product "J" produced by Sanshin Chemical Industry Co., Ltd.), benzyl-4-methoxycarbonyloxyphenylmethylsulfonium triflate (experimental product "T" produced by Sanshin Chemical Industry Co., Ltd.), 4-acetoxyphenylbenzylmethylsulfonium triflate (experimental product "U" produced by Sanshin Chemical Industry Co., Ltd.), 4-acetoxyphenylmethyl-4-methylbenzylsulfonium triflate, 4-acetoxyphenyldimethylsulfonium triflate (experimental product "V" produced by Sanshin Chemical Industry Co., Ltd.), 4-hydroxyphenyldimethylsulfonium hexafluorophosphate, benzyl-4-hydroxyphenylmethylsulfonium hexafluorophosphate, 2-methylbenzyl-4-hydroxyphenylmethylsulfonium hexafluorophosphate, 4-methylbenzyl-4-hydroxyphenylmethylsulfonium hexafluorophosphate, 4-hydroxyphenylmethyl-1-naphthylmethylsulfonium hexafluorophosphate, 4-methoxycarbonyloxyphenyldimethylsulfonium hexafluorophosphate, benzyl-4-methoxycarbonyloxyphenylmethylsulfonium hexafluorophosphate, 4-acetoxyphenylbenzylmethylsulfonium hexafluorophosphate (experimental product "A" produced by Sanshin Chemical Industry Co., Ltd.), 4-acetoxyphenylmethyl-4-methylbenzylsulfonium hexafluorophosphate, 4-acetoxyphenyldimethylsulfonium hexafluorophosphate (trade name "SI-150" produced by Sanshin Chemical Industry Co., Ltd.), "SI-180L" (produced by Sanshin Chemical Industry Co., Ltd.), 4-hydroxyphenyldimethylsulfonium hexafluoroantimonate, benzyl-4-hydroxyphenylmethylsulfonium hexafluoroantimonate, 2-methylbenzyl-4-hydroxyphenylmethylsulfonium hexafluoroantimonate, 4-methylbenzyl-4-hydroxyphenylmethylsulfonium hexafluoroantimonate, 4-hydroxyphenylmethyl-1-naphthylmethylsulfonium hexafluoroantimonate, 4-methoxycarbonyloxyphenyldimethylsulfonium hexafluoroantimonate, benzyl-4-methoxycarbonyloxyphenylmethylsulfonium hexafluoroantimonate, 4-acetoxyphenylbenzylmethylsulfonium hexafluoroantimonate, 4-acetoxyphenylmethyl-4-methylbenzylsulfonium hexafluoroantimonate, 4-acetoxyphenyldimethylsulfonium hexafluoroantimonate, 4-acetoxyphenyldimethylsulfonium hexafluoroantimonate, benzyl-4-hydroxyphenylmethylsulfonium hexafluoroantimonate, etc.

Examples of the aromatic diazonium salts include chlorobenzenediazonium hexafluorophosphate, dimethylaminobenzenediazonium hexafluoroantimonate, naphthyldiazonium hexafluorophosphate, dimethylaminonaphthyldiazonium tetrafluoroborate, etc.

Examples of the diaryl iodonium salts include diphenyliodonium tetrafluoroborate, diphenyliodonium hexafluoroantimonate, diphenyliodonium hexafluorophosphate, diphenyliodonium triflate, 4,4'-di-t-butyl-diphenyliodonium triflate, 4,4'-di-t-butyl-diphenyliodonium tetrafluoroborate, 4,4'-di-t-butyl-diphenyliodonium hexafluorophosphate, etc.

Examples of the triaryl sulfonium salts include triphenylsulfonium tetrafluoroborate, triphenylsulfonium hexafluorophosphate, triphenylsulfonium hexafluoroantimonate, tri(p-chlorophenyl)sulfonium tetrafluoroborate, tri(p-chlorophenyl)sulfonium hexafluorophosphate, tri(p-chlorophenyl)sulfonium hexafluoroantimonate, 4-t-butyltriphenylsulfonium hexafluorophosphate, etc.

Examples of the triaryl selenium salts include triphenylselenium tetrafluoroborate, triphenylselenium hexafluorophosphate, triphenylselenium hexafluoroantimonate, di(chlorophenyl)phenylselenium tetrafluoroborate, di(chlorophenyl)phenylselenium hexafluorophosphate, di(chlorophenyl)phenylselenium hexafluoroantimonate, etc.

Examples of the sulfonic acid ester compounds include benzoin tosylate, p-nitrobenzyl-9,10-ethoxyanthracene-2-sulfonate, 2-nitrobenzyl tosylate, 2,6-dinitrobenzyl tosylate, 2,4-dinitrobenzyl tosylate, etc.

Examples of the halogen-containing compounds include 2-chloro-2-phenylacetophenone, 2,2',4'-trichloroacetophenone, 2,4,6-tris(trichloromethyl)-s-triazine, 2-(p-methoxystyryl)-4,6-bis(trichloromethyl)-s-triazine, 2-phenyl-4,6-bis(trichloromethyl)-s-triazine, 2-(p-methoxyphenyl)-4,6-bis(trichloromethyl)-s-triazine, 2-(4'-methoxy-1'-naphthyl)-4,6-bis(trichloromethyl)-s-triazine, bis-2-(4-chlorophenyl)-1,1,1-trichloroethane, bis-1-(4-chlorophenyl)-2,2,2-trichloroethanol, bis-2-(4-methoxyphenyl)-1,1,1-trichloroethane, etc.

Examples of other thermal acid generating agents include 5-norbornene-2,3-dicarboxyimidyl triflate (trade name "NDI-105" produced by Midori Kagaku Co., Ltd.), 5-norbornene-2,3-dicarboxyimidyl tosylate (trade name "NDI-101" produced by Midori Kagaku Co., Ltd.), 4-methylphenylsulfonyloxyimino-α-(4-methoxyphenyl)acetonitrile (trade name "PAI-101" produced by Midori Kagaku Co., Ltd.), trifluoromethylsulfonyloxyimino-α-(4-methoxyphenyl)acetonitril e (trade name "PAI-105" produced by Midori Kagaku Co., Ltd.), 9-camphorsulfonyloxyimino α-4-methoxyphenylacetonitrile (trade name "PAI-106" produced by Midori Kagaku Co., Ltd.), 1,8-naphthalimidyl butanesulfonate (trade name "NAI-1004" produced by Midori Kagaku Co., Ltd.), 1,8-naphthalimidyl tosylate (trade name "NAI-101" produced by Midori Kagaku Co., Ltd.), 1,8-naphthalimidyl triflate (trade name "NAI-105" produced by Midori Kagaku Co., Ltd.), 1,8-naphthalimidyl nonafluorobutanesulfonate (trade name "NAl-109" produced by Midori Kagaku Co., Ltd.), etc.

The siloxane resin composition of this invention can also be adjusted in concentration using a solvent, to have an appropriate solid content. The concentration is not especially limited, but in the case where spin coating is used to form a film, the solid content is generally 5 to 50 wt%. The siloxane resin composition of this invention contains 1-t-butoxy-2-propanol, but can also further contain one or more other solvents. In this case, it is preferred that the 1-t-butoxy-2-propanol content is 20 wt% based on the amount of all the solvents. More preferred is 50 wt% or more, and further more preferred is 80 wt% or more. If the 1-t-butoxy-2-propanol content is increased, the capability to cover the level differences can be enhanced. Examples of other solvents include ethers such as ethylene glycol monomethyl ether, ethylene glycol monoethyl ether, propylene glycol monomethyl ether, propylene glycol monoethyl ether, propylene glycol monopropyl ether, propylene glycol monobutyl ether, ethylene glycol dimethyl ether, ethylene glycol diethyl ether and ethylene glycol dibutyl ether, acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate and butyl lactate, ketones such as acetylacetone, methyl propyl ketone, methyl butyl ketone, methyl isobutyl ketone, cyclopentanone and 2-heptanone, alcohols such as methanol, ethanol, propanol, butanol, isobutyl alcohol, pentanol, 4-methyl-2-pentanol, 3-methyl-2-butanol, 3-methyl-3-methoxy-1-butanol and diacetone alcohol, aromatic hydrocarbons such as toluene and xylene, γ-butyrolactone, N-methylpyrrolidinone, etc. Among them, especially preferred examples of solvents include propylene glycol monomethyl ether, propylene glycol monomethyl ether acetate, propylene glycol monoethyl ether, propylene glycol monopropyl ether, propylene glycol monobutyl ether, diacetone alcohol, γ-butyrolactone.

It is preferred that the content of all the solvents in the siloxane resin composition of this invention is 30 parts by weight or more per 100 parts by weight of the entire siloxane compound. A more preferred amount is 50 parts by weight or more. On the other hand, a preferred amount is 9900 parts by weight or less, and a more preferred amount is 5000 parts by weight or less.

The siloxane resin composition of this invention may contain, as required, a viscosity modifier, surfactant, stabilizer, colorant, vitrifying agent.

Further, the siloxane resin composition of this invention contains a photosensitive agent, so that it can be photosensitive. For example, in the case where the siloxane resin composition contains a quinonediazide-based photosensitive agent, if the exposed area is dissolved by an alkali aqueous solution such as a tetramethylammmonium hydroxide aqueous solution, a positive relief pattern can be obtained. Further, if it contains a photo crosslinking agent or photo acid generating agent, etc., it is negatively photosensitive.

As the quinonediazide-based photosensitive agent, a compound in which sulfonic acid of naphthoquinonediazide is bound to a compound having a phenolic hydroxyl group as an ester is preferred. Examples of the compound having a phenolic hydroxyl group include Bis-Z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-PZ, BisP-IPZ, BisCR-IPZ, BisOCP-IPZ, BisOIPP-CP, Bis26X-IPZ, BisOTBP-CP, TekP-4HBPA (TetrakisP-DO-BPA), TrisP-HAP, TrisP-PA, BisOFP-Z, BisRS-2P, BisPG-26X, BisRS-3P, BisOC-OCHP, BisPC-OCHP, Bis25X-OCHP, Bis26X-OCHP, BisOCHP-OC, Bis236T-OCHP, Methylenetris-FR-CR, BisRS-26X, BisRS-OCHP (respectively trade names, produced by Honshu Chemical Industry Co., Ltd.), BIR-OC, BIP-PC, BIR-PC, BIR-PTBP, BIR-PCHP, BIP-BIOC-F, 4PC, BIR-BIPC-F, TEP-BIP-A (respectively trade names, produced by Asahi Organic Chemicals Industry Co., Ltd.), 4,4'-sulfonyldiphenol (produced by Wako Pure Chemical Industries, Ltd.), BPFL (trade name, produced by JFE Chemical Corporation). Among them, Bis-Z, TekP-4HBPA, TrisP-HAP, TrisP-PA, BisRS-2P, BisRS-3P, BIR-PC, BIR-PTBP, BIR-BIPC-F, 4,4'-sulfonyldiphenol and BPFL are more preferred.

A preferably used quinonediazide-based photosensitive agent can be a compound obtained by introducing 4-naphthoquinonediazidesulfonic acid or 5-naphthoquinonediazidesulfonic acid into such a compound with a phenolic hydroxyl group as an ester bond, but a compound other than it can also be used.

It is preferred that the content of the quinonediazide-based photosensitive agent is 1 part by weight or more per 100 parts by weight of the siloxane compound. Amore preferred content is 2 parts by weight or more. On the other hand, a preferred amount is 50 parts by weight or less, and a more preferred amount is 10 parts by weight or less. If the amount is 1 part by weight or more, a pattern can be formed at a practical sensitivity, and if it is 50 parts by weight or less, a resin composition excellent in transparency and pattern resolution can be obtained.

It is preferred that the molecular weight of the quinonediazide-based photosensitive agent is 300 or more. More preferred is 350 or more. On the other hand, preferred is 1000 or less and more preferred is 800 or less. If the molecular weight is 300 or more, an effect of preventing the dissolution of the non-exposed area can be obtained, and if the molecular weight is 1000 or less, a good relief pattern free from scum, etc. can be obtained.

In the case where a quinonediazide-based photosensitive agent is contained, it can happen that the unreactive photosensitive agent remains in the non-exposed area and that after curing with heating, the filmmay be colored. For obtaining a transparent cured film, it is preferred to irradiate the entire film surface with ultraviolet light after completion of development for decomposing the quinonediazide compound and subsequently to heat for curing.

Examples of the photo crosslinking agent include bisazide compounds such as 4,4'-diazidechalcone, 2,6-di-(4'-azidebenzylidene)cyclohexanone and 2,6-di-(4'-azidebenzylidene)-4-methylcyclohexanone.

The photo acid generating agent can be selected from onium salt compounds, halogen-containing compounds, diazoketone compounds, diazomethane compounds, sulfone compounds, sulfonic acid ester compounds, sulfone imide compounds.

Examples of the onium salt compounds include diazonium salts, ammonium salts, iodonium salts, sulfonium salts, phosphonium salts, oxonium salts, etc. Preferred onium salts include diphenyliodonium triflate, diphenyliodonium pyrenesulfonate, diphenyliodonium dodecylbenzenesulfonate, triphenylsulfonium triflate, triphenylsulfonium hexafluoroantimonate, triphenylsulfonium naphthalenesulfonate, (hydroxyphenyl)benzylmethylsulfonium toluenesulfonate, etc.

Examples of the halogen-containing compounds include haloalkyl group-containing hydrocarbon compounds, haloalkyl group-containing heterocyclic compounds, etc. Preferred halogen-containing compounds include 1,1-bis(4-chlorophenyl)-2,2,2-trichloroethane, 2-phenyl-4,6-bis(trichloromethyl)-s-triazine, 2-naphthyl-4,6-bis(trichloromethyl)-s-triazine, etc.

Examples of the diazoketone compounds include 1,3-diketo-2-diazo compounds, diazobenzoquinone compounds, diazonaphthoquinone compounds, etc. Preferred diazoketone compounds include the ester obtained from 1,2-naphthoquinonediazide-4-sulfonic acid and 2,2,3,4,4'-tetrahydroxybenzophenone, the ester obtained from 1,2-naphthoquinonediazide-4-sulfonic acid and 1,1,1-tris(4-hydroxyphenyl)ethane, etc.

Examples of the diazomethane compounds include bis(trifluoromethylsulfonyl)diazomethane, bis(cyclohexylsulfonyl)diazomethane, bis(phenylsulfonyl)diazomethane, bis(p-tolylsulfonyl)diazomethane, bis(2,4-xylylsulfonyl)diazomethane, bis(p-chlorophenylsulfonyl)diazomethane, methylsulfonyl-p-toluenesulfonyldiazomethane, cyclohexylsulfonyl(1,1-dimethylethylsulfonyl)diazomethane, bis(1,1-dimethylethylsulfonyl)diazomethane, phenylsulfonyl(benzoyl)diazomethane, etc.

Examples of the sulfone compounds include β-ketosulfone compounds, β-sulfonylsulfone compounds, etc. Preferred compounds include 4-trisphenacylsulfone, mesitylphenacylsulfone, bis(phenylsulfonyl)methane, etc.

Examples of the sulfonic acid ester compounds include alkylsulfonic acid esters, haloalkylsulfonic acid esters, arylsulfonic acid esters, iminosulfonates, etc. Examples of the sulfonic acid compounds include benzoin tosylate, pyrogallol trimesylate, nitrobenzyl-9,10-diethoxyanthracene-2-sulfonate, etc.

Examples of the sulfone imide compounds include N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hepto-5-ene-2,3-di carboxylimide, N-(trifluoromethylsulfonyloxy)-7-oxabicyclo[2.2.1]hepto_5-ene-2,3-dicarboxylimide, N-(trifluoromethylsulfonyloxy)bicyclo[2.2.1]heptane-5,6-oxy-2, 3-dicarboxylimide, N-(trifluoromethylsulfonyloxy)naphthyldicarboxylimide, N-(camphorsulfonyloxy)succinimide, N-(camphorsulfonyloxy)phthalimide, N-(camphorsulfonyloxy)diphenylmaleimide, N-(camphorsulfonyloxy)bicyclo[2.2.1]hepto-5-ene-2,3-dicarboxyl imide, N-(camphorsulfonyloxy)-7-oxabicyclo[2.2.1]hepto-5-ene-2,3-dica rboxylimide, N-(camphorsulfonyloxy)bicyclo[2.2.1]heptane-5,6-oxy-2,3-dicarb oxylimide, N-(camphorsulfonyloxy)naphthyldicarboxylimide, N-(4-methylphenylsulfonyloxy)succinimide, N-(4-methylphenylsulfonyloxy)phthalimide, N-(4-methylphenylsulfonyloxy)diphenylmaleimide, N-(4-methylphenylsulfonyloxy)bicyclo[2.2.1]hepto-5-ene-2,3-dic arboxylimide, N-(4-methylphenylsulfonyloxy)-7-oxabicyclo[2.2.1]hepto-5-ene-2,3-dicarboxylimide, N-(4-methylphenylsulfonyloxy)bicyclo[2.2.1]heptane-5,6-oxy-2,3 -dicarboxylimide, N-(4-methylphenylsulfonyloxy)naphthyldicarboxylimide, N-(2-trifluoromethylphenylsulfonyloxy)succinimide, N-(2-trifluoromethylphenylsulfonyloxy)phthalimide, N-(2-trifluoromethylphenylsulfonyloxy)diphenylmaleimide, N-(2-trifluoromethylphenylsulfonyloxy)bicyclo[2.2.1]hepto-5-en e-2,3-dicarboxylimide, N-(2-trifluoromethylphenylsulfonyloxy)-7-oxabicyclo[2.2.1]hept o-5-ene-2,3-dicarboxylimide, N-(2-trifluoromethylphenylsulfonyloxy)bicyclo[2.2.1]heptane-5, 6-oxy-2,3-dicarboxymide, N-(2-trifluoromethylphenylsulfonyloxy)naphthyldicarboxylimide, N-(4-fluorophenylsulfonyloxy)succinimide, N-(2-fluorophenylsulfonyloxy)phthalimide, N-(4-fluorophenylsulfonyloxy)diphenylmaleimide, N-(4-fluorophenylsulfonyloxy)bicyclo[2.2.1]hepto-5-ene-2,3-dic arboxylimide, N-(4-fluorophenylsulfonyloxy)-7-oxabicyclo[2.2.1]hepto-5-ene-2 ,3-dicarboxylimide, N-(4-fluorophenylsulfonyloxy)bicyclo[2.2.1]heptane-5,6-oxy-2,3 -dicarboxylimide, N-(4-fluorophenylsulfonyloxy)naphthyldicarboxylimide, etc.

Other examples of the photo acid generating agents include 5-norbornene-2,3-dicarboxyimidyl triflate (trade name "NDI-105" produced by Midori Kagaku Co., Ltd.), 5-norbornene-2,3-dicarboxyimidyl tosylate (trade name "NDI-101" produced by Midori Kagaku Co., Ltd.), 4-methylphenylsulfonyloxyimino-α-(4-methoxyphenyl)acetonitrile (trade name "PAI-101" produced by Midori Kagaku Co., Ltd.), trifluoromethylsulfonyloxyimino-α-(4-methoxyphenyl)acetonitril e (trade name "PAI-105" produced by Midori Kagaku Co., Ltd.), 9-camphor-sulfonyloxyimino α-4-methoxyphenylacetonitrile (trade name "PAI-106" produced by Midori Kagaku Co., Ltd.), 1,8-naphthalimidyl butanesulfonate (trade name "NAI-1004" produced by Midori Kagaku Co., Ltd.), 1,8-naphthalimidyl tosylate (trade name "NAI-101" produced by Midori Kagaku Co., Ltd.), 1,8-naphthalimidyl triflate(trade name "NAI-105" produced by Midori Kagaku Co., Ltd.), 1,8-naphthalimidyl nonafluorobutanesulfonate (trade name "NAI-109" produced by Midori Kagaku Co., Ltd.), etc.

Any one of these photo acid generating agents can be used alone or two or more of them can also be used together. It is preferred that the photo acid generating agent content is 0.01 part by weight per 100 parts by weight of the siloxane compound. A more preferred content is 0.1 part by weight or more. On the other hand, a preferred content is 20 parts by weight or less, and a more preferred content is 10 parts by weight or less. If the amount of the photo acid generating agent is in the aforesaid range, a good pattern free from scum or development failure can be obtained.

The siloxane resin composition of this invention may contain any of various surfactants to achieve higher flowability at the time of coating. The surfactant used is not especially limited, and can be selected, for example, from fluorine-based surfactants, silicone-based surfactants, polyalkylene oxide-based surfactants, poly(meth)acrylate-based surfactants.

Examples of the fluorine-based surfactants include compounds respectively having a fluoroalkyl or fluoroalkylene group at least at any of the ends, main chain and side chains thereof such as 1,1,2,2-tetrafluorooctyl(1,1,2,2-tetrafluoropropyl) ether, 1,1,2,2-tetrafluorooctylhexyl ether, octaethylene glycol di(1,1,2,2-tetrafluorobutyl) ether, hexaethylene glycol (1,1,2,2,3,3-hexafluoropentyl) ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-[3-(perfluorooctanesulfonamide)propyl]-N,N'-dimethyl-N-carbo xymethyleneammonium betaine, perfluoroalkylsulfonamide propyltrimethylammonium salt, perfluoroalkyl-N-ethylsulfonylglycine salt, bis(N-perfluorooctylsulfonyl-N-ethylaminoethyl) phosphate and monoperfluoroalkyl ethylphosphoric acid ester. Further, commercially available fluorine-based surfactants include Megafac F142D, Megafac F172, Megafac F173, Megafac F183 (respectively produced by Dainippon Ink and Chemicals, Inc.), Eftop EF301, Eftop EF303, Eftop EF352 (produced by Shin-Akita Kasei K.K.), Fluorad FC-430, Fluorad FC-431 (respectively produced by Sumitomo 3M Ltd.), Asahi Guard AG710, Surflon S-382, Surflon SC-101, Surflon SC-102, Surflon SC-103, Surflon SC-104, Surflon SC-105, Surflon SC-106 (respectively produced by Asahi Glass Co., Ltd.), BM-1000, BM-1100 (respectively produced by Yusho Co., Ltd.), NBX-15, FTX-218 (respectively produced by NEOS Co., Ltd.), etc.

Commercially available silicone-based surfactants include SH28PA, SH7PA, SH21PA, SH30PA, ST94PA (respectively produced by Down Corning Toray Co. , Ltd.), BYK-333 (produced by BYK Japan KK), etc. Examples of other surfactants include polyoxyethylene lauryl ether, polyoxyethylene stearyl ether, polyoxyethylene nonyl phenyl ether, polyoxyethylene distearate, etc.

Generally the surfactant content is 0.0001 to 1 wt% based on the amount of the siloxane resin composition. Any one of the surfactants can be used alone or two or more of them can also be used together.

A substrate can be coated with the siloxane resin composition of this invention, to form a coating film, and it can be heated, to be dried and cured, for forming a cured film.

Preferably used coating methods for the siloxane resin composition of this invention include micro gravure coating, spin coating, slit coating, dip coating, curtain flow coating, roll coating, spray coating, flow coating.

The heating and drying conditions should be decided in reference to the substrate and the resin composition used. Usually it is preferred to treat at a temperature of room temperature to 400°C for 0.5 to 240 minutes. A more preferred curing temperature range is 100 to 400°C, and a further more preferred range is 150 to 400°C. The heating and drying can also be performed under reduced pressure.

The thickness of the coating film and the thickness of the cured film are not especially limited, but generally both the thicknesses are in a range from 0.001 to 100 µm.

If the siloxane resin composition of this invention is photosensitive, a pattern can be formed as desired by photolithography. For example, the following process can be used to form the pattern. The polysiloxane resin composition of this invention is applied and heated and dried at a desired temperature of about 80°C to about 130°C, exposed to a pattern using a desired exposure light source, and subsequently developed using a desired developer, to obtain a desired pattern. After formation of the pattern, the film can be heated and cured, to obtain a pattern of a cured film. In this process, after completion of exposure, the film can be baked as required. The exposure light source is not especially limited, and can be ultraviolet radiation of i-line, g-line or h-line, etc., or KrF (wavelength 248 nm) laser or ArF (wavelength 193 nm) laser, etc.

The coating film and the cured film formed of the siloxane resin composition of this invention can be used as on-chip microlenses formed on solid imaging devices, a hard coating layer used for reflection prevention films, a buffer coating of semiconductor devices, a planarlization material, a protective film of liquid crystal displays, and any of various optical articles such as interlayer insulation films, waveguide forming materials, phase shifter materials and various protective films. Especially in the case where the siloxane resin composition of this invention contains titanium oxide particles or zirconium oxide particles, the cured film is good in compatibility between high transparency and relatively high refractive index. So, it can be especially suitable as on-chip microlenses formed on solid imaging devices and a hard coating layer for reflection prevention films. In such applications, it is preferred that the refractive index of the cured film is 1.55 or more. More preferred is 1.60 or more. Further, in the case where the siloxane resin composition of this invention contains fluorine atoms, the cured film can exhibit high transparency and low refractive index. So, it can be preferably used as a planarization film or as any of various reflection prevention films formed on the on-chip microlenses of solid imaging devices. In such applications, it is preferred that the refractive index of the cured film is 1.50 or less. More preferred is 1.45 or less. For example, in the semiconductor device described in JP2003-86778A, an intra-layer lens can be coated with the siloxane resin composition of this invention and the coating film can be cured to form a planarization film. On the planarization film, a color filter, protective film, external microlens, etc. can be formed one after another, to form a solid imaging device with high condensation efficiency. In any application, it is preferred that the transparency of the cured film with a thickness of 1 µm at a wavelength of 400 nm is 95% or more. More preferred is 98% or more.

### [Examples]

This invention is explained below in reference to examples but is not limited thereto or thereby. Meanwhile, in the following examples, properties were evaluated according to the following methods.

### Preparation of cured film

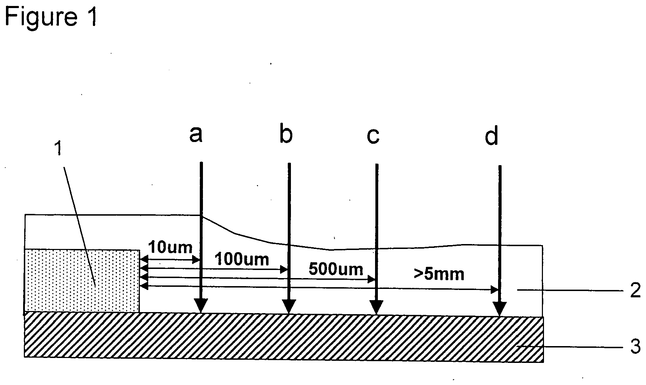

As shown in Fig. 1, a 6-inch silicon substrate 3 with a level difference of 0.7 µm in height formed according to polyimide pattern 1 was coated with a siloxane resin composition, and the coating was pre-baked using a hotplate (SCW-636 produced by Dainippon Screen Mfg. Co., Ltd.) at 120°C for 3 minutes to obtain a coating film. The coating film was heated on a hotplate at 200°C for 5 minutes in air atmosphere, to obtain a cured film.

### Thickness measurement of coating film and cured film

Lambda Ace STM-602 produced by Dainippon Screen Mfg. Co., Ltd. was used to measure the thicknesses of a coating film and a cured film.

### Evaluation of the capability of a coating film to cover a level difference

The thickness of a coating film was measured at measuring points a, b and c near a step with a level difference of 0.7 µm in height formed according to the polyimide pattern and at a measuring point d of a flat portion free from the level difference. As shown in Fig. 1, the measuring point a is a point with a distance of 10 µm from an end of the polyimide pattern 1; the measuring point b is a point with a distance of 100 µm; the measuring point c is a point with a distance of 500 µm; and the measuring point d is a point with a distance of 5 mm or more in a portion free from the level difference. The capability to cover the level difference was evaluated in reference to the value of {(the largest value of a to c) - d}/d. If the value is smaller, the variation of the film thickness due to the level difference is smaller, and the capability to cover the level difference is better.

### Evaluation of coating irregularity

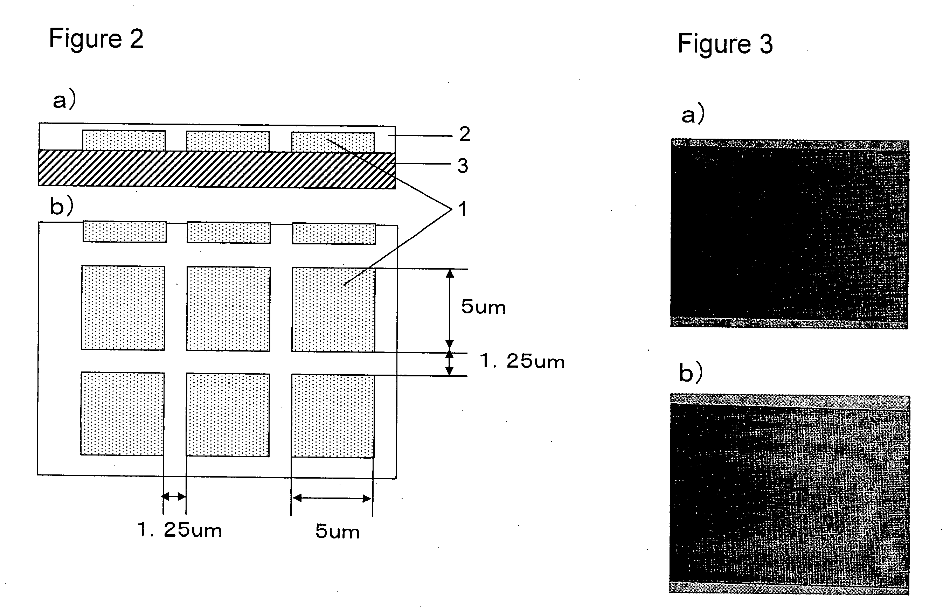

A microlens array pattern was coated with a siloxane resin composition, to obtain a substrate used for evaluating coating irregularity. A cross sectional view of the coating irregularity evaluation substrate is shown in Fig. 2a and the top view of it is shown in Fig. 2b. Since the microlens array pattern is formed on the silicon substrate 3 as the polyimide pattern 1, 5 µm square projections with a height of 0.7 µm are formed at 1.25 µm intervals. Whether or not coating irregularity of the siloxane resin composition occurred on the pattern was evaluated by observation with an optical microscope. An example of evaluation results is shown in Figs. 3. The result as shown in Fig. 3a is evaluated as "Coating is irregular" and the result as shown in Fig. 3b, as "Coating is not irregular."

### Measurement of transparency

A 1.0 µm thick cured film formed on a 5 cm square glass substrate was used to measure the transparency of 400 nm by an ultraviolet-visible spectrophotometer (UV-260 produced by Shimadzu Corporation).

### Measurement of refractive index

A 1.0 µm thick cured film formed on a 5 cm square glass substrate was used to measure the refractive index at a room temperature of 22°C at a wavelength of 632.8 nm (using a He-Ne laser as a light source) by a prism coupler (Model 2010 produced by Metricon). Meanwhile, the refractive index measured here is the refractive index in the direction perpendicular to the film surface (TE).

Synthesis Example 1 Synthesis of a quinonediazide compound In a dry nitrogen stream, 21.22 g (0.05 mole) of TrisP-PA (trade name, produced by Honshu Chemical Industry Co., Ltd.) and 26.8 g (0.1 mole) of 5-naphthoquinonediazidesulfonic acid chloride (NAC-5 produced by Toyo Gosei Kogyo K.K.) were dissolved into 450 g of 1,4-dioxane, and the mixture was kept at room temperature. To the mixture, a mixture consisting of 50 g of 1,4-dioxane and 12.65 g of triethylamine was added dropwise to ensure that the temperature in the system did not exceed 35°C. After completion of dropwise addition, the mixture was stirred at 40°C for 2 hours. The triethylamine salt was filtered away, and the filtrate was added into water. Subsequently the precipitate was collected by filtration and washed with 1 liter of 1% hydrochloric acid aqueous solution. Then, it was washed further with 2 liters of water twice. The precipitate was dried using a vacuum dryer, to obtain the quinonediazide compound represented by the following formula:

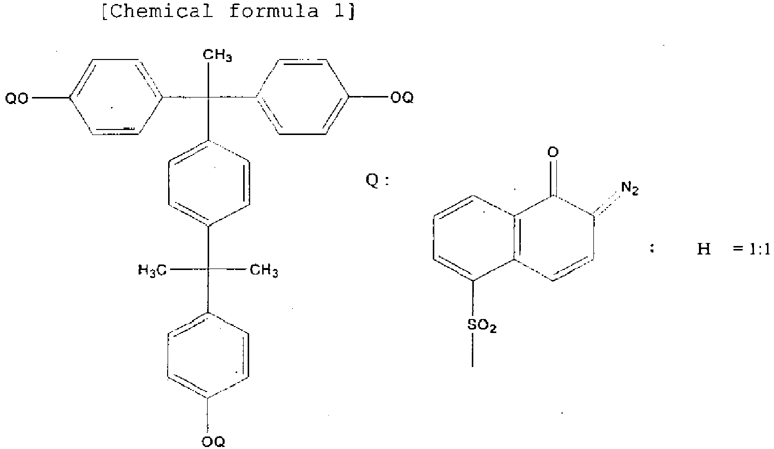

### Working Example 1 (for reference)

A reaction vessel was charged with 20.4 g (0.15 mol) of methyltrimethoxysilane, 69.4 g (0.35 mol) of phenyltrimethoxysilane and 190 g of 1-ethoxy-2-propanol, and into the solution, 30.6 g of water and 0.48 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours, to perform a reaction while the methanol produced by hydrolysis was distilled away. Then, the solution was further heated and stirred at a bath temperature of 130°C for 2 hours and cooled to room temperature, to obtain polymer solution A (solid content 33 wt%).

Twenty grams of the obtained polymer solution A was taken, and 30 g of 1-t-butoxy-2-propanol was added to it for dilution, to obtain resin composition 1.

A silicon substrate with a level difference as described before was coated with the obtained resin composition 1, and the coating was pre-baked at 120°C for 3 minutes to obtain a coating film. The capability to cover the level difference and the coating irregularity were evaluated. Separately a coating film similarly formed on a glass substrate was cured, and the transparency and the refractive index of the cured film were measured.

### Working Example 2 (for reference)

Hydrolysis and condensation were performed as described in Working Example 1, except that 1-t-butoxy-2-propanol was used instead of 1-ethoxy-2-propanol, to obtain polymer solution B (solid content 30 wt%). Twenty grams of the obtained polymer solution B was taken, and 30 g of 1-t-butoxy-2-propanol was added to it for dilution, to obtain resin composition 2. The obtained resin composition 2 was used for evaluation as described in Working Example 1.

### Working Example 3 (for reference)

A reaction vessel was charged with 147 g (1.08 mol) of methyltrimethoxysilane, 118 g (0.54 mol) of trifluoropropyltrimethoxysilane and 320 g of 1-t-butoxy-2-propanol, and into the solution, 100 g of water and 0.88 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution C (solid content 30 wt%).

Twenty grams of the obtained polymer solution was taken, and 25 g of 1-t-butoxy-2-propanol was added to it for dilution, to obtain resin composition 3. The fluorine content of the siloxane resin in the resin composition was 22.5 wt%. The obtained resin composition 3 was used for evaluation as described in Working Example 1.

### Working Example 4 (for reference)

Ten grams of the polymer solution B obtained in Working Example 2 was taken, and 5 g of "Optlake TR-520" (solid concentration 30%, γ-butyrolactone solution) as silicon oxide-titanium oxide composite particles ("Optlake TR-520" produced by Catalysts & Chemicals Industries Co., Ltd.) and 15 g of 1-t-butoxy-2-propanol were added to it. The mixture was stirred to obtain resin composition 4. The obtained resin composition 4 was used for evaluation as described in Working Example 1.

### Working Example 5 (for reference)

A reaction vessel was charged with 20.4 g (0.15 mol) of methyltrimethoxysilane, 69.4 g (0.35 mol) of phenyltrimethoxysilane and 190 g of 1-t-butoxy-2-propanol, and into the solution, 27.0 g of water and 0.31 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 1 hour to perform a reaction, while the methanol produced by hydrolysis was distilled away. Then, the solution was further heated and stirred at a bath temperature of 130°C for 4 hours and cooled to room temperature, to obtain polymer solution D (solid content 41.5%).

Twenty grams of the obtained solution D and 0.58 g of the quinonediazide compound obtained in Synthesis Example 1 were dissolved into 30 g of 1-t-butoxy-2-propanol, to obtain resin composition 5.

A silicon substrate with a level difference as described before was coated with the obtained resin composition 5, and the coating was pre-baked at 90°C for 2 minutes, to obtain a coating film. The capability to cover the level difference and the coating irregularity were evaluated. Separately a coating film similarly formed on a glass substrate was cured, and the transparency and the refractive index of the cured film were measured.

Subsequently the positive photosensitivity was evaluated according to the following procedure. A 6-inch silicon wafer was spin-coated with the resin composition 5. Then, the coating film was pre-baked by a 100°C hotplate (Mark-7) for 2 minutes to prepare a 1 µm thick pre-baked film. The pre-baked film was exposed with exposure values of 0 to 800 mJ/cm² at 25 mJ/cm² steps using an i-line stepper (DSW-8000 produced by GCA). Subsequently 2.38 wt% tetramethylammmonium (TMAH) aqueous solution (ELM-D produced by Mitsubishi Gas Chemical Company, Inc.) was used for development for 45 seconds, followed by rinsing with pure water. The obtained patterns were observed with an optical microscope. At an exposure value of 350 mJ/cm², a 5 µm wide positive pattern had been resolved.

### Working Example 6 (for reference)

A reaction vessel was charged with 147.1 g (1.08 mol) of methyltrimethoxysilane, 117.9 g (0.54 mol) of 1,1,1-trifluoropropyltrimethoxysilane, 44.4 g (0.18 mol) of 2-(3,4-epoxycyclohexyl)ethyltrimethoxysilane and 320 g of 1-t-butoxy-2-propanol. Into the solution, 100 g of water and 0.77 g of phosphoric acid were added dropwise with stirring to ensure that the reaction temperature did not exceed 40°C. After completion of dropwise addition, a distillation device was attached to the flask, and the obtained solution was heated and stirring at a bath temperature of 70°C for 1 hour. Further, the solution was heated and stirred at a bath temperature of 115°C for 2 hours and cooled to room temperature, to obtain polymer solution E (solid content 47.9 wt%).

Twenty grams of the obtained polymer solution E and 0.1 g of a photo acid generating agent (PAI-101 produced by Midori Kagaku Co., Ltd.) were dissolved into 30 g of 1-t-butoxy-2-propanol, to obtain resin composition 6. The fluorine content of the siloxane resin in the resin composition was 17 wt%.

The obtained resin composition 6 was used to evaluate the capability to cover the level difference and the coating irregularity and to measure the transparency and the refractive index as described in Working Example 5.

Subsequently the negative photosensitivity was evaluated according to the following procedure. A 6-inch silicon wafer was spin-coated with the resin composition 6. Then, the coating film was pre-baked by a 90°C hotplate (Mark-7) for 2 minutes to prepare a 1 µm thick pre-baked film. The pre-baked film was exposed with exposure values of 0 to 800 mJ/cm² at 25 mJ/cm² steps using an i-line stepper (DSW-8000 produced by GCA). Further, a 90°C hotplate was used for PEB (post exposure baking) for 1 minute. Subsequently 2.38 wt% tetramethylammmonium (TMAH) aqueous solution (ELM-D produced by Mitsubishi Gas Chemical Company, Inc.) was used for development for 60 seconds, followed by rinsing with pure water. The obtained patterns were observed with an optical microscope. At an exposure value of 200 mJ/cm², a 5 µm wide negative pattern had been resolved.

### Working Example 7 (for reference)

A reaction vessel was charged with 12.02 g (0.10 mol) of dimethyldimethoxysilane, 47.68 g (0.35 mol) of methyltrimethoxysilane, 9.61 g (0.05 mol) of tetraethoxysilane and 200 g of 1-t-butoxy-2-propanl, and into the solution, 26.1 g of water and 0.488 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution F (solid content 28 wt%).

Twenty grams of the obtained polymer solution F was taken, and 20 g of 1-t-butoxy-2-propanol was added to it for dilution, to obtain resin composition 7. The obtained resin composition 7 was used for evaluation as described in Working Example 1.

### Working Example 8 (for reference)

A reaction vessel was charged with 14.82 g (0.10 mol) of vinyltrimethoxysilane, 47.68 g (0.35 mol) of methyltrimethoxysilane, 9.61 g (0.05 mol) of tetraethoxysilane and 200 g of 1-t-butoxy-2-propanol, and into the solution, 29.7 g of water and 0.488 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution G (solid content 26 wt%).

Twenty grams of the obtained polymer solution G was taken, and 20 g of 1-t-butoxy-2-propanol was added to it for dilution, to obtain resin composition 8. The obtained resin composition 8 was used for evaluation as described in Working Example 1.

### Comparative Example 1

Twenty grams of the polymer solution obtained in Working Example 1 was taken, and 30 g of 1-n-butoxy-2-propanol was added for dilution, to obtain resin composition A1. The obtained resin composition A1 was used for evaluation as described in Working Example 1.

### Comparative Example 2

Twenty parts of the polymer solution obtained in Working Example 1 was taken, and 35 g of propylene glycol monomethyl ether acetate was added to it for dilution, to obtain resin composition A2. The obtained resin composition A2 was evaluated as described in Working Example 1.

### Comparative Example 3

Twenty grams of the polymer solution obtained in Working Example 1 was taken, and 18 g of ethyl lactate was added to it for dilution, to obtain resin composition A3. The obtained resin composition A3 was used for evaluation as described in Working Example 1.

Evaluation results of Working Examples 1 to 8 and Comparative Examples 1 to 3 are shown in Table 1.

### [Table 1]

### [Industrial applicability]

The siloxane resin composition of this invention allows coating even on a substrate with a level difference without coating irregularity and is good in the capability to cover the level difference of the substrate. The cured film obtained by curing the obtained coating film can be suitably used as optical lenses such as microlens arrays of solid imaging devices, a planarization film for TFTs of liquid crystal displays and organic EL displays, or as a reflection prevention film, reflection prevention film, reflection prevention sheet, optical filter, etc.

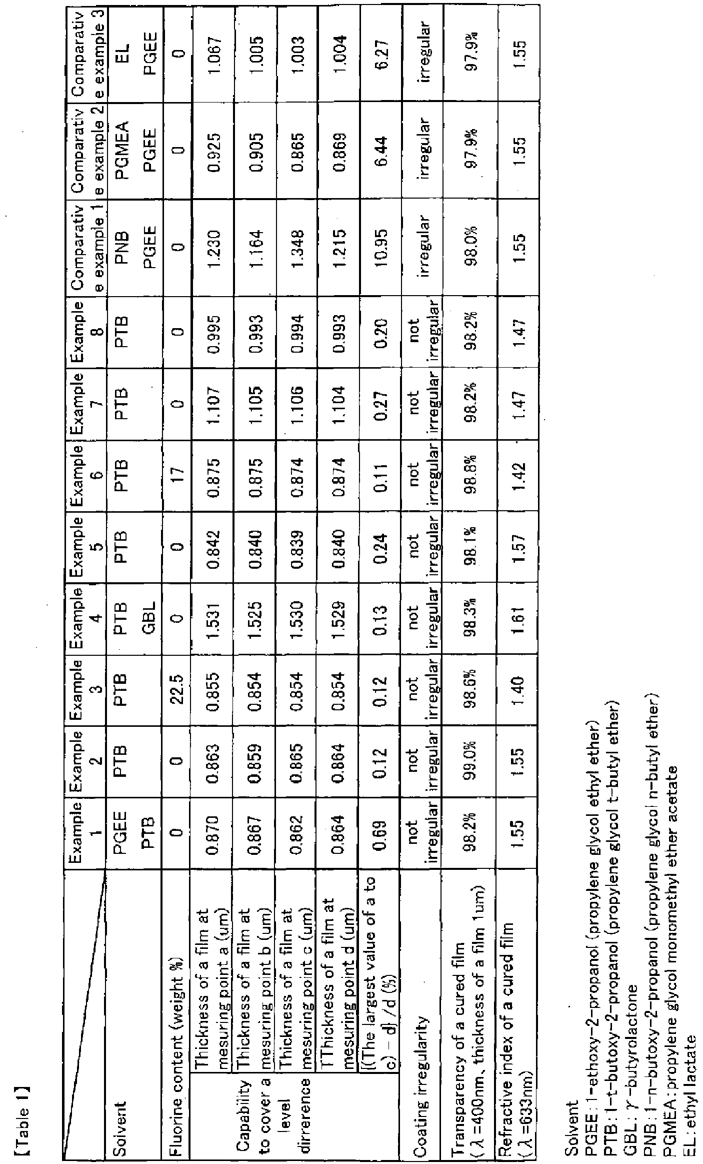

In Table 1, Examples 1 to 8 are Reference Examples. propylene glycol monobutyl ether, ethylene glycol dimethyl ether, ethylene glycol diethyl ether and ethylene glycol dibutyl ether, acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate and butyl lactate, ketones such as acetylacetone, methyl propyl ketone, methyl butyl ketone, methyl isobutyl ketone, cyclopentanone and 2-heptanone, alcohols such as methanol, ethanol, propanol, butanol, isobutyl alcohol, pentanol, 4-methyl-2-pentanol, 3-methyl-2-butanol, 3-methyl-3-methoxy-1-butanol and diacetone alcohol, aromatic hydrocarbons such as toluene and xylene, γ-butyrolactone, N-methylpyrrolidinone, etc. Among them, especially preferred examples of solvents include propylene glycol monomethyl ether, propylene glycol monomethyl ether acetate, propylene glycol monoethyl ether, propylene glycol monopropyl ether, propylene glycol monobutyl ether, diacetone alcohol, γ-butyrolactone, etc.

It is preferred that the content of all the solvents in the siloxane resin composition of this invention is 30 parts by weight or more per 100 parts by weight of the entire siloxane compound. A more preferred amount is 50 parts by weight or more. On the other hand, a preferred amount is 9900 parts by weight or less, and a more preferred amount is 5000 parts by weight or less.

The siloxane resin composition of this invention may contain, as required, a viscosity modifier, surfactant, stabilizer, colorant, vitrifying agent, etc.

Further, the siloxane resin composition of this invention can also contain any of various photosensitive agents, so that it can be photosensitive. For example, in the case where the siloxane resin composition contains a quinonediazide-based photosensitive agent, if the exposed area is dissolved by an alkali aqueous solution such as a tetramethylammmonium hydroxide aqueous solution, a positive relief pattern can be obtained. Further, if it contains a photo crosslinking agent or photo acid generating agent, etc., it can be negatively photosensitive.

As the quinonediazide-based photosensitive agent, a compound in which sulfonic acid of naphthoquinonediazide is bound to a compound having a phenolic hydroxyl group as an ester is preferred. Examples of the compound having a phenolic hydroxyl group include Bis-Z, BisOC-Z, BisOPP-Z, BisP-CP, Bis26X-Z, BisOTBP-Z, BisOCHP-Z, BisOCR-CP, BisP-MZ, BisP-EZ, Bis26X-CP, BisP-PZ, BisP-IPZ, BisCR-IPZ, BisOCP-IPZ, BisOIPP-CP, Bis26X-IPZ, BisOTBP-CP, TekP-4HBPA (TetrakisP-DO-BPA), TrisP-HAP, TrisP-PA, BisOFP-Z, BisRS-2P, BisPG-26X, BisRS-3P, BisOC-OCHP, BisPC-OCHP, Bis25X-OCHP, Bis26X-OCHP, BisOCHP-OC, Bis236T-OCHP, Methylenetris-FR-CR, BisRS-26X, BisRS-OCHP (respectively trade names, produced by Honshu Chemical Industry Co., Ltd.), BIR-OC, BIP-PC, BIR-PC, BIR-PTBP, BIR-PCHP, BIP-BIOC-F, 4PC, BIR-BIPC-F, TEP-BIP-A (respectively trade names, produced by Asahi Organic Chemicals Industry Co., Ltd.), 4,4'-sulfonyldiphenol (produced by Wako Pure Chemical Industries, Ltd.), BPFL (trade name, produced by JFE Chemical Corporation). Among them, Bis-Z, TekP-4HBPA, TrisP-HAP, TrisP-PA, BisRS-2P, BisRS-3P, BIR-PC, BIR-PTBP, BIR-BIPC-F, 4,4'-sulfonyldiphenol and BPFL are more preferred.

A preferably used quinonediazide-based photosensitive agent can be a compound obtained by introducing 4-naphthoquinonediazidesulfonic acid or 5-naphthoquinonediazidesulfonic acid into such a compound with a phenolic hydroxyl group as an ester bond, but a compound other than it can also be used.

It is preferred that the content of the quinonediazide-based photosensitive agent is 1 part by weight or more per 100 parts by weight of the siloxane compound. A more preferred content is 2 parts by weight or more. On the other hand, a preferred amount is 50 parts by weight or less, and a more preferred amount is 10 parts by weight or less. If the amount is 1 part by weight or more, a pattern can be formed at a practical sensitivity, and if it is 50 parts by weight or less, a resin composition excellent in transparency and pattern resolution can be obtained.

It is preferred that the molecular weight of the quinonediazide-based photosensitive agent is 300 or more. More preferred is 350 or more. On the other hand, preferred is 1000 or less and more preferred is 800 or less. If the molecular weight is 300 or more, an effect of preventing the dissolution of the non-exposed area can be obtained, and if the molecular weight is 1000 or less, a good relief pattern free from scum, etc. can be obtained.

In the case where a quinonediazide-based photosensitive agent is contained, it can happen that the unreactive photosensitive agent remains in the non-exposed area and that after curing with heating, the film may be colored. For obtaining a transparent cured film, it is preferred to irradiate the entire film surface with ultraviolet light after completion of development for decomposing the quinonediazide compound and subsequently to heat for curing.

Examples of the photo crosslinking agent include bisazide compounds such as 4,4'-diazidechalcone, 2,6-di-(4'-azidebenzylidene)cyclohexanone and 2,6-di-(4'-azidebenzylidene)-4-methylcyclohexanone.

The photo acid generating agent can be selected from onium salt compounds, halogen-containing compounds, diazoketone compounds, diazomethane compounds, sulfone compounds, sulfonic acid ester compounds, sulfone imide compounds, etc.

Examples of the onium salt compounds include diazonium salts, ammonium salts, iodonium salts, sulfonium salts, phosphonium salts, oxonium salts, etc. Preferred onium salts include diphenyliodonium triflate, diphenyliodonium pyrenesulfonate, diphenyliodonium dodecylbenzenesulfonate, triphenylsulfonium triflate, triphenylsulfonium hexafluoroantimonate, triphenylsulfonium naphthalenesulfonate, (hydroxyphenyl)benzylmethylsulfonium toluenesulfonate, etc.

Examples of the halogen-containing compounds include haloalkyl group-containing hydrocarbon compounds, haloalkyl group-containing heterocyclic compounds, etc. Preferred halogen-containing compounds include 1,1-bis(4-chlorophenyl)-2,2,2-trichloroethane, 2-phenyl-4,6-bis (trichloromethyl)-s-triazine, 2-naphthyl-4,6-bis(trichloromethyl)-s-triazine, etc.

Examples of the diazoketone compounds include 1,3-diketo-2-diazo compounds, diazobenzoquinone compounds, diazonaphthoquinone compounds, etc. Preferred diazoketone compounds include the ester obtained from 1,2-naphthoquinonediazide-4-sulfonic acid and 2,2,3,4,4'-tetrahydroxybenzophenone, the ester obtained from 1,2-naphthoquinonediazide-4-sulfonic acid and 1,1,1-tris(4-hydroxyphenyl)ethane, etc.

Examples. of the diazomethane compounds include
bis(trifluoromethylsulfonyl)diazomethane,
bis(cyclohexylsulfonyl)diazomethane,
bis(phenylsulfonyl)diazomethane,
bis(p-tolylsulfonyl)diazomethane,
bis(2,4-xylylsulfonyl)diazomethane,
bis(p-chlorophenylsulfonyl)diazomethane,
methylsulfonyl-p-toluenesulfonyldiazomethane,
cyclohexylsulfonyl(1,1-dimethylethylsulfonyl)diazomethane,
bis(1,1-dimethylethylsulfonyl)diazomethane,
phenylsulfonyl(benzoyl)diazomethane, etc.

Examples of the sulfone compounds include β-ketosulfone compounds, β-sulfonylsulfone compounds, etc. Preferred compounds include 4-trisphenacylsulfone, mesitylphenacylsulfone, bis(phenylsulfonyl)methane, etc.

Examples of the sulfonic acid ester compounds include alkylsulfonic acid esters, haloalkylsulfonic acid esters, arylsulfonic acid esters, iminosulfonates, etc. Examples of the sulfonic acid compounds include benzoin tosylate, pyrogallol trimesylate, nitrobenzyl-9,10-diethoxyanthracene-2-sulfonate, etc.

Examples of the sulfone imide compounds include N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hepto-5-ene-2,3-di carboxylimide, N-(trifluoromethylsulfonyloxy)-7-oxabicyclo[2.2.1]hepto-5-ene-2,3-dicarboxylimide, N-(trifluoromethylsulfonyloxy)bicyclo[2.2.1]heptane-5,6-oxy-2, 3-dicarboxylimide, N-(trifluoromethylsulfonyloxy)naphthyldicarboxylimide, N-(camphorsulfonyloxy)succinimide, N-(camphorsulfonyloxy)phthalimide, N-(camphorsulfonyloxy)diphenylmaleimide, N-(camphorsulfonyloxy)bicyclo[2.2.1]hepto-5-ene-2,3-dicarboxyl imide, N-(camphorsulfonyloxy)-7-oxabicyclo[2.2.1]hepto-5-ene-2,3-dica rboxylimide, N-(camphorsulfonyloxy)bicyclo[2.2.1]heptane-5,6-oxy-2,3-dicarb oxylimide, N-(camphorsulfonyloxy)naphthyldicarboxylimide, N-(4-methylphenylsulfonyloxy)succinimide, N-(4-methylphenylsulfonyloxy)phthalimide, N-(4-methylphenylsulfonyloxy)diphenylmaleimide, N-(4-methylphenylsulfonyloxy)bicyclo[2.2.1]hepto-5-ene-2,3-dic arboxylimide, N-(4-methylphenylsulfonyloxy)-7-oxabicyclo[2.2.1]hepto-5-ene-2 ,3-dicarboxylimide, N-(4-methylphenylsulfonyloxy)bicyclo[2.2.1]heptane-5,6-oxy-2,3 -dicarboxylimide, N-(4-methylphenylsulfonyloxy)naphthyldicarboxylimide, N-(2-trifluoromethylphenylsulfonyloxy)succinimide, N-(2-trifluoromethylphenylsulfonyloxy)phthalimide, N-(2-trifluoromethylphenylsulfonyloxy)diphenylmaleimide, N-(2-trifluoromethylphenylsulfonyloxy)bicyclo[2.2.1]hepto-5-en e-2,3-dicarboxylimide, N-(2-trifluoromethylphenylsulfonyloxy)-7-oxabicyclo[2.2.1]hept o-5-ene-2,3-dicarboxylimide, N-(2-trifluoromethylphenylsulfonyloxy)bicyclo[2.2.1]heptane-5, 6-oxy-2,3-dicarboxylimide, N-(2-trifluoromethylphenylsulfonyloxy)naphthyldicarboxylimide, N-(4-fluorophenylsulfonyloxy)succinimide, N-(2-fluorophenylsulfonyloxy)phthalimide, N-(4-fluorophenylsulfonyloxy)diphenylmaleimide, N-(4-fluorophenylsulfonyloxy)bicyclo[2.2.1]hepto-5-ene-2,3-dic arboxylimide, N-(4-fluorophenylsulfonyloxy)-7-oxabicyclo[2.2.1]hepto-5-ene-2 ,3-dicarboxylimide, N-(4-fluorophenylsulfonyloxy)bicyclo[2.2.1]heptane-5,6-oxy-2,3 -dicarboxylimide, N-(4-fluorophenylsulfonyloxy)naphthyldicarboxylimide, etc.

Other examples of the photo acid generating agents include 5-norbornene-2,3-dicarboxyimidyl triflate (trade name "NDI-105" produced by Midori Kagaku Co., Ltd.), 5-norbornene-2,3-dicarboxyimidyl tosylate (trade name "NDI-101" produced by Midori Kagaku Co., Ltd.), 4-methylphenylsulfonyloxyimino-α-(4-methoxyphenyl)acetonitrile (trade name "PAI-101" produced by Midori Kagaku Co., Ltd.), trifluoromethylsulfonyloxyimino-α-(4-methoxyphenyl)acetonitril e (trade name "PAI-105" produced by Midori Kagaku Co., Ltd.), 9-camphor-sulfonyloxyimino α-4-methoxyphenylacetonitrile (trade name "PAI-106" produced by Midori Kagaku Co., Ltd.), 1,8-naphthalimidyl butanesulfonate (trade name "NAI-1004" produced by Midori Kagaku Co., Ltd.), 1,8-naphthalimidyl tosylate (trade name "NAI-101" produced by Midori Kagaku Co., Ltd.), 1,8-naphthalimidyl triflate(trade name "NAI-105" produced by Midori Kagaku Co., Ltd.), 1,8-naphthalimidyl nonafluorobutanesulfonate (trade name "NAI-109" produced by Midori Kagaku Co., Ltd.), etc.

Any one of these photo acid generating agents can be used alone or two or more of them can also be used together. It is preferred that the photo acid generating agent content is 0.01 part by weight or more per 100 parts by weight of the siloxane compound. A more preferred content is 0.1 part by weight or more. On the other hand, a preferred content is 20 parts by weight or less, and a more preferred content is 10 parts by weight or less. If the amount of the photo acid generating agent is in the aforesaid range, a good pattern free from scum or development failure can be obtained.

The siloxane resin composition of this invention may contain any of various surfactants to achieve higher flowability at the time of coating. The surfactant used is not especially limited, and can be selected, for example, from fluorine-based surfactants, silicone-based surfactants, polyalkylene oxide-based surfactants, poly(meth)acrylate-based surfactants, etc.

Examples of the fluorine-based surfactants include compounds respectively having a fluoroalkyl or fluoroalkylene group at least at any of the ends, main chain and side chains thereof such as 1,1,2,2-tetrafluorooctyl(1,1,2,2-tetrafluoropropyl) ether, 1,1,2,2-tetrafluorooctylhexyl ether, octaethylene glycol di(1,1,2,2-tetrafluorobutyl) ether, hexaethylene glycol (1,1,2,2,3,3-hexafluoropentyl) ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-[3-(perfluorooctanesulfonamide)propyl]-N,N'-dimethyl-N-carbo xymethyleneammonium betaine, perfluoroalkylsulfonamide propyltrimethylammonium salt, perfluoroalkyl-N-ethylsulfonylglycine salt, bis(N-perfluorooctylsulfonyl-N-ethylaminoethyl) phosphate and monoperfluoroalkyl ethylphosphoric acid ester. Further, commercially available fluorine-based surfactants include Megafac F142D, Megafac F172, Megafac F173, Megafac F183 (respectively produced by Dainippon Ink and Chemicals, Inc.), Eftop EF301, Eftop EF303, Eftop EF352 (produced by Shin-Akita Kasei K.K.), Fluorad FC-430, Fluorad FC-431 (respectively produced by Sumitomo 3M Ltd.), Asahi Guard AG710, Surflon S-382, Surflon SC-101, Surflon SC-102, Surflon SC-103, Surflon SC-104, Surflon SC-105, Surflon SC-106 (respectively produced by Asahi Glass Co., Ltd.), BM-1000, BM-1100 (respectively produced by Yusho Co., Ltd.), NBX-15, FTX-218 (respectively produced by NEOS Co., Ltd.), etc.

Commercially available silicone-based surfactants include SH28PA, SH7PA, SH21PA, SH30PA, ST94PA (respectively produced by Down Corning Toray Co., Ltd.), BYK-333 (produced by BYK Japan KK), etc. Examples of other surfactants include polyoxyethylene lauryl ether, polyoxyethylene stearyl ether, polyoxyethylene nonyl phenyl ether, polyoxyethylene distearate, etc.

Generally the surfactant content is 0.0001 to 1 wt% based on the amount of the siloxane resin composition. Any one of the surfactants can be used alone or two or more of them can also be used together.

A substrate can be coated with the siloxane resin composition of this invention, to form a coating film, and it can be heated, to be dried and cured, for forming a cured film.

Preferably used coating methods for the siloxane resin composition of this invention include micro gravure coating, spin coating, slit coating, dip coating, curtain flow coating, roll coating, spray coating, flow coating, etc.

The heating and drying conditions should be decided in reference to the substrate and the resin composition used. Usually it is preferred to treat at a temperature of room temperature to 400°C for 0.5 to 240 minutes. A more preferred curing temperature range is 100 to 400°C, and a further more preferred range is 150 to 400°C. The heating and drying can also be performed under reduced pressure.

The thickness of the coating film and the thickness of the cured film are not especially limited, but generally both the thicknesses are in a range from 0.001 to 100 µm.

If the siloxane resin composition of this invention is photosensitive, a pattern can be formed as desired by photolithography. For example, the following process can be used to form the pattern. The polysiloxane resin composition of this invention is applied and heated and dried at a desired temperature of about 80°C to about 130°C, exposed to a pattern using a desired exposure light source, and subsequently developed using a desired developer, to obtain a desired pattern. After formation of the pattern, the film can be heated and cured, to obtain a pattern of a cured film. In this process, after completion of exposure, the film can be baked as required. The exposure light source is not especially limited, and can be ultraviolet radiation of i-line, g-line or h-line, etc., or KrF (wavelength 248 nm) laser or ArF (wavelength 193 nm) laser, etc.

The coating film and the cured film formed of the siloxane resin composition of this invention can be used as on-chip microlenses formed on solid imaging devices, a hard coating layer used for reflection prevention films, a buffer coating of semiconductor devices, a planarlization material, a protective film of liquid crystal displays, and any of various optical articles such as interlayer insulation films, waveguide forming materials, phase shifter materials and various protective films. Especially in the case where the siloxane resin composition of this invention contains titanium oxide particles or zirconium oxide particles, the cured film is good in compatibility between high transparency and relatively high refractive index. So, it can be especially suitable as on-chip microlenses formed on solid imaging devices and a hard coating layer for reflection prevention films. In such applications, it is preferred that the refractive index of the cured film is 1.55 or more. More preferred is 1.60 or more. Further, in the case where the siloxane resin composition of this invention contains fluorine atoms, the cured film can exhibit high transparency and low refractive index. So, it can be preferably used as a planarization film or as any of various reflection prevention films formed on the on-chip microlenses of solid imaging devices. In such applications, it is preferred that the refractive index of the cured film is 1.50 or less. More preferred is 1.45 or less. For example, in the semiconductor device described in JP2003-86778A, an intra-layer lens can be coated with the siloxane resin composition of this invention and the coating film can be cured to form a planarization film. On the planarization film, a color filter, protective film, external microlens, etc. can be formed one after another, to form a solid imaging device with high condensation efficiency. In any application, it is preferred that the transparency of the cured film with a thickness of 1 µm at a wavelength of 400 nm is 95% or more. More preferred is 98% or more.

### [Examples]

This invention is explained below in reference to examples but is not limited thereto or thereby. Meanwhile, in the following examples, properties were evaluated according to the following methods.

### Preparation of cured film

As shown in Fig. 1, a 6-inch silicon substrate 3 with a level difference of 0.7 µm in height formed according to polyimide pattern 1 was coated with a siloxane resin composition, and the coating was pre-baked using a hotplate (SCW-636 produced by Dainippon Screen Mfg. Co., Ltd.) at 120°C for 3 minutes to obtain a coating film. The coating film was heated on a hotplate at 200°C for 5 minutes in air atmosphere, to obtain a cured film.

### Thickness measurement of coating film and cured film

Lambda Ace STM-602 produced by Dainippon Screen Mfg. Co., Ltd. was used to measure the thicknesses of a coating film and a cured film.

### Evaluation of the capability of a coating film to cover a level difference

The thickness of a coating film was measured at measuring points a, b and c near a step with a level difference of 0.7 µm in height formed according to the polyimide pattern and at a measuring point d of a flat portion free from the level difference. As shown in Fig. 1, the measuring point a is a point with a distance of 10 µm from an end of the polyimide pattern 1; the measuring point b is a point with a distance of 100 µm; the measuring point c is a point with a distance of 500 µm; and the measuring point d is a point with a distance of 5 mm or more in a portion free from the level difference. The capability to cover the level difference was evaluated in reference to the value of {(the largest value of a to c) - d}/d. If the value is smaller, the variation of the film thickness due to the level difference is smaller, and the capability to cover the level difference is better.

### Evaluation of coating irregularity

A microlens array pattern was coated with a siloxane resin composition, to obtain a substrate used for evaluating coating irregularity. A cross sectional view of the coating irregularity evaluation substrate is shown in Fig. 2a and the top view of it is shown in Fig. 2b. Since the microlens array pattern is formed on the silicon substrate 3 as the polyimide pattern 1, 5 µm square projections with a height of 0.7 µm are formed at 1.25 µm intervals. Whether or not coating irregularity of the siloxane resin composition occurred on the pattern was evaluated by observation with an optical microscope. An example of evaluation results is shown in Figs. 3. The result as shown in Fig. 3b is evaluated as "Coating is irregular" and the result as shown in Fig. 3a, as "Coating is not irregular."

### Measurement of transparency

A 1.0 µm thick cured film formed on a 5 cm square glass substrate was used to measure the transparency of 400 nm by an ultraviolet-visible spectrophotometer (UV-260 produced by Shimadzu Corporation).

### Measurement of refractive index

A 1.0 µm thick cured film formed on a 5 cm square glass substrate was used to measure the refractive index at a room temperature of 22°C at a wavelength of 632.8 nm (using a He-Ne laser as a light source) by a prism coupler (Model 2010 produced by Metricon). Meanwhile, the refractive index measured here is the refractive index in the direction perpendicular to the film surface (TE) .

### Synthesis Example 1 Synthesis of a quinonediazide compound

In a dry nitrogen stream, 21.22 g (0.05 mole) of TrisP-PA (trade name, produced by Honshu Chemical Industry Co., Ltd.) and 26.8 g (0.1 mole) of 5-naphthoquinonediazidesulfonic acid chloride (NAC-5 produced by Toyo Gosei Kogyo K.K.) were dissolved into 450 g of 1,4-dioxane, and the mixture was kept at room temperature. To the mixture, a mixture consisting of 50 g of 1,4-dioxane and 12.65 g of triethylamine was added dropwise to ensure that the temperature in the system did not exceed 35°C. After completion of dropwise addition, the mixture was stirred at 40°C for 2 hours. The triethylamine salt was filtered away, and the filtrate was added into water. Subsequently the precipitate was collected by filtration and washed with 1 liter of 1% hydrochloric acid aqueous solution. Then, it was washed further with 2 liters of water twice. The precipitate was dried using a vacuum dryer, to obtain the quinonediazide compound represented by the following formula:

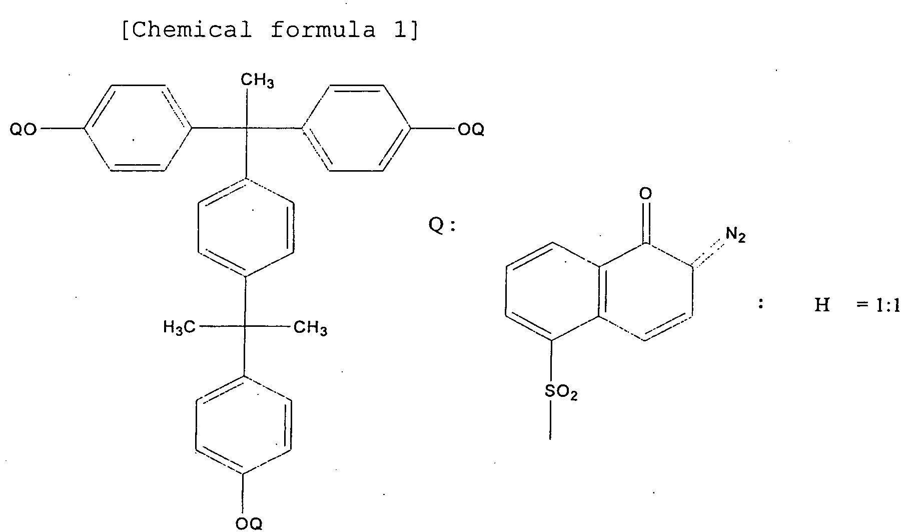

### Working Example 1

A reaction vessel was charged with 20.4 g (0.15 mol) of methyltrimethoxysilane, 69.4 g (0.35 mol) of phenyltrimethoxysilane and 190 g of 1-ethoxy-2-propanol, and into the solution, 30.6 g of water and 0.48 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours, to perform a reaction while the methanol produced by hydrolysis was distilled away. Then, the solution was further heated and stirred at a bath temperature of 130°C for 2 hours and cooled to room temperature, to obtain polymer solution A (solid content 33 wt%).

Twenty grams of the obtained polymer solution A was taken, and 30 g of 1-t-butoxy-2-propanol was added to it for dilution, to obtain resin composition 1.

A silicon substrate with a level difference as described before was coated with the obtained resin composition 1, and the coating was pre-baked at 120°C for 3 minutes to obtain a coating film. The capability to cover the level difference and the coating irregularity were evaluated. Separately a coating film similarly formed on a glass substrate was cured, and the transparency and the refractive index of the cured film were measured.

### Working Example 2

Hydrolysis and condensation were performed as described in Working Example 1, except that 1-t-butoxy-2-propanol was used instead of 1-ethoxy-2-propanol, to obtain polymer solution B (solid content 30 wt%). Twenty grams of the obtained polymer solution B was taken, and 30 g of 1-t-butoxy-2-propanol was added to it for dilution, to obtain resin composition 2. The obtained resin composition 2 was used for evaluation as described in Working Example 1.

### Working Example 3

A reaction vessel was charged with 147 g (1.08 mol) of methyltrimethoxysilane, 118 g (0.54 mol) of trifluoropropyltrimethoxysilane and 320 g of 1-t-butoxy-2-propanol, and into the solution, 100 g of water and 0.88 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution C (solid content 30 wt%).

Twenty grams of the obtained polymer solution was taken, and 25 g of 1-t-butoxy-2-propanol was added to it for dilution, to obtain resin composition 3. The fluorine content of the siloxane resin in the resin composition was 22.5 wt%. The obtained resin composition 3 was used for evaluation as described in Working Example 1.

### Working Example 4

Ten grams of the polymer solution B obtained in Working Example 2 was taken, and 5 g of "Optlake TR-520" (solid concentration 30%, γ-butyrolactone solution) as silicon oxide-titanium oxide composite particles ("Optlake TR-520" produced by Catalysts & Chemicals Industries Co., Ltd.) and 15 g of 1-t-butoxy-2-propanol were added to it. The mixture was stirred to obtain resin composition 4. The obtained resin composition 4 was used for evaluation as described in Working Example 1.

### Working Example 5

A reaction vessel was charged with 20.4 g (0.15 mol) of methyltrimethoxysilane, 69.4 g (0.35 mol) of phenyltrimethoxysilane and 190 g of 1-t-butoxy-2-propanol, and into the solution, 27.0 g of water and 0.31 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 1 hour to perform a reaction, while the methanol produced by hydrolysis was distilled away. Then, the solution was further heated and stirred at a bath temperature of 130°C for 4 hours and cooled to room temperature, to obtain polymer solution D (solid content 41.5%).

Twenty grams of the obtained solution D and 0.58 g of the quinonediazide compound obtained in Synthesis Example 1 were dissolved into 30 g of 1-t-butoxy-2-propanol, to obtain resin composition 5.

A silicon substrate with a level difference as described before was coated with the obtained resin composition 5, and the coating was pre-baked at 90°C for 2 minutes, to obtain a coating film. The capability to cover the level difference and the coating irregularity were evaluated. Separately a coating film similarly formed on a glass substrate was cured, and the transparency and the refractive index of the cured film were measured.

Subsequently the positive photosensitivity was evaluated according to the following procedure. A 6-inch silicon wafer was spin-coated with the resin composition 5. Then, the coating film was pre-baked by a 100°C hotplate (Mark-7) for 2 minutes to prepare a 1 µm thick pre-baked film. The pre-baked film was exposed with exposure values of 0 to 800 mJ/cm² at 25 mJ/cm² steps using an i-line stepper (DSW-8000 produced by GCA). Subsequently 2.38 wt% tetramethylammmonium (TMAH) aqueous solution (ELM-D produced by Mitsubishi Gas Chemical Company, Inc.) was used for development for 45 seconds, followed by rinsing with pure water. The obtained patterns were observed with an optical microscope. At an exposure value of 350 mJ/cm², a 5 µm wide positive pattern had been resolved.

### Working Example 6

A reaction vessel was charged with 147.1 g (1.08 mol) of methyltrimethoxysilane, 117.9 g (0.54 mol) of 1,1,1-trifluoropropyltrimethoxysilane, 44.4 g (0.18 mol) of 2-(3,4-epoxycyclohexyl)ethyltrimethoxysilane and 320 g of 1-t-butoxy-2-propanol. Into the solution, 100 g of water and 0.77 g of phosphoric acid were added dropwise with stirring to ensure that the reaction temperature did not exceed 40°C. After completion of dropwise addition, a distillation device was attached to the flask, and the obtained solution was heated and stirring at a bath temperature of 70°C for 1 hour. Further, the solution was heated and stirred at a bath temperature of 115°C for 2 hours and cooled to room temperature, to obtain polymer solution E (solid content 47.9 wt%).

Twenty grams of the obtained polymer solution E and 0.1 g of a photo acid generating agent (PAI-101 produced by Midori Kagaku Co., Ltd.) were dissolved into 30 g of 1-t-butoxy-2-propanol, to obtain resin composition 6. The fluorine content of the siloxane resin in the resin composition was 17 wt%.

The obtained resin composition 6 was used to evaluate the capability to cover the level difference and the coating irregularity and to measure the transparency and the refractive index as described in Working Example 5.

Subsequently the negative photosensitivity was evaluated according to the following procedure. A 6-inch silicon wafer was spin-coated with the resin composition 6. Then, the coating film was pre-baked by a 90°C hotplate (Mark-7) for 2 minutes to prepare a 1 µm thick pre-baked film. The pre-baked film was exposed with exposure values of 0 to 800 mJ/cm² at 25 mJ/cm² steps using an i-line stepper (DSW-8000 produced by GCA). Further, a 90°C hotplate was used for PEB (post exposure baking) for 1 minute. Subsequently 2.38 wt% tetramethylammmonium (TMAH) aqueous solution (ELM-D produced by Mitsubishi Gas Chemical Company, Inc.) was used for development for 60 seconds, followed by rinsing with pure water. The obtained patterns were observed with an optical microscope. At an exposure value of 200 mJ/cm², a 5 µm wide negative pattern had been resolved.

### Working Example 7

A reaction vessel was charged with 12.02 g (0.10 mol) of dimethyldimethoxysilane, 47.68 g (0.35 mol) of methyltrimethoxysilane, 9.61 g (0.05 mol) of tetraethoxysilane and 200 g of 1-t-butoxy-2-propanl, and into the solution, 26.1 g of water and 0.488 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution F (solid content 28 wt%).

Twenty grams of the obtained polymer solution F was taken, and 20 g of 1-t-butoxy-2-propanol was added to it for dilution, to obtain resin composition 7. The obtained resin composition 7 was used for evaluation as described in Working Example 1.

### Working Example 8

A reaction vessel was charged with 14.82 g (0.10 mol) of vinyltrimethoxysilane, 47.68 g (0.35 mol) of methyltrimethoxysilane, 9.61 g (0.05 mol) of tetraethoxysilane and 200 g of 1-t-butoxy-2-propanol, and into the solution, 29.7 g of water and 0.488 g of phosphoric acid were added dropwise with stirring to ensure that the reaction temperature did not exceed 40°C. After completion of dropwise addition, a distillation device was attached to the flask, and the obtained solution was heated and stirred at a bath temperature of 105°C for 2.5 hours to perform a reaction, while the methanol produced by hydrolysis was distilled away. Then, the solution was further heated and stirred at a bath temperature of 130°C for 2 hours and cooled to room temperature, to obtain polymer solution G (solid content 26 wt%).

Twenty grams of the obtained polymer solution G was taken, and 20 g of 1-t-butoxy-2-propanol was added to it for dilution, to obtain resin composition 8. The obtained resin composition 8 was used for evaluation as described in Working Example 1.

### Comparative Example 1

Twenty grams of the polymer solution obtained in Working Example 1 was taken, and 30 g of 1-n-butoxy-2-propanol was added for dilution, to obtain resin composition A1. The obtained resin composition A1 was used for evaluation as described in Working Example 1.

### Comparative Example 2

Twenty parts of the polymer solution obtained in Working Example 1 was taken, and 35 g of propylene glycol monomethyl ether acetate was added to it for dilution, to obtain resin composition A2. The obtained resin composition A2 was evaluated as described in Working Example 1.

### Comparative Example 3

Twenty grams of the polymer solution obtained in Working Example 1 was taken, and 18 g of ethyl lactate was added to it for dilution, to obtain resin composition A3. The obtained resin composition A3 was used for evaluation as described in Working Example 1.

Evaluation results of Working Examples 1 to 8 and Comparative Examples 1 to 3 are shown in Table 1.

[Table 1]

### [Industrial applicability]

The siloxane resin composition of this invention allows coating even on a substrate with a level difference without coating irregularity and is good in the capability to cover the level difference of the substrate. The cured film obtained by curing the obtained coating film can be suitably used as optical lenses such as microlens arrays of solid imaging devices, a planarization film for TFTs of liquid crystal displays and organic EL displays, or as a reflection prevention film, reflection prevention sheet, optical filter, etc.

## Claims

1. A siloxane resin composition comprising a siloxane compound, 1-t-butoxy-2-propanol and metal compound particles, wherein the siloxane resin composition further comprises a quinonediazide-based photosensitive agent and is positive photosensitive or a photo acid generating agent and is negative photosensitive.

2. A siloxane resin composition, according to claim 1, which contains the siloxane compound by 10 wt% or more based on the total solid content.

3. A siloxane resin composition, according to claim 1 or 2, wherein the siloxane compound includes the hydrolysis product and/or condensation product of the one or more alkoxysilane compounds selected from the following general formulae (1) through (3).
R¹Si(OR⁴)₃ (1)
(R¹ denotes a hydrogen atom, alkyl group, alkenyl group, aryl group or any of the substitution products thereof; and each R⁴ denotes a methyl group, ethyl group, propyl group, isopropyl group or butyl group, and the plural R⁴s can be identical with or different from each other.)
R²R³Si(OR⁵) (2)
(R² and R³ denote, respectively a hydrogen atom, alkyl group, alkenyl group, aryl group or any of the substitution products thereof, and they can be identical without or different from each other; and each R⁵ denotes a methyl group, ethyl group, propyl group, isopropyl group or butyl group, and the plural R⁵s can be identical with or different from each other.)
Si(OR⁶)₄ (3)
(each R⁶ denotes a methyl group, ethyl group, propyl group, isopropyl group or butyl group, and the plural R⁶s can be identical with or different from each other.)

4. A siloxane resin composition, according to any one of claims 1 through 3, wherein the siloxane compound contains an organic group with fluorine atoms.

5. A siloxane resin composition, according to claim 4, which contains fluorine atoms by 10 wt% or more based on the total solid content.

6. A cured film obtained by curing the siloxane resin composition as set forth in any one of claims 1 through 5.

7. A cured film, according to claim 6, which has a refractive index measured according to the method mentioned in the description of 1.45 or less at a wavelength of 632.8 nm.

8. An optical article having the cured film as set forth in claim 6.

9. A solid imaging device having the cured film as set forth in claim 6 on microlenses.

10. A method for producing the siloxane resin composition as set forth in claim 1, comprising the step of condensing the hydrolysis product of an alkoxysilane compound by reaction in the presence of 1-t-butoxy-2-propanol to obtain the siloxane compound.

## Patentansprüche

1. Siloxanharzzusammensetzung umfassend eine Siloxanverbindung, 1-t-Butoxy-2-propanol und Metallverbindungspartikel, wobei die Siloxanharzverbindung ferner ein Chinondiazid-basiertes lichtempfindliches Mittel umfasst und positiv-lichtempfindlich ist oder ein Photosäure-erzeugendes Mittel umfasst und negativ-lichtempfindlich ist.

2. Siloxanharzzusammensetzung nach Anspruch 1, welche die Siloxanverbindung zu 10 Gew.-% oder mehr basierend auf dem Gesamtfeststoffgehalt enthält.

3. Siloxanharzzusammensetzung nach Anspruch 1 oder 2, wobei die Siloxanverbindung das Hydrolyseprodukt und/oder ein Kondensationsprodukt einer oder mehrerer Alkoxysilanverbindungen ausgewählt aus den folgenden allgemeinen Formeln (1) bis (3) umfasst.
R¹Si(OR⁴)₃ (1)
(R¹ bezeichnet ein Wasserstoffatom, eine Alkylgruppe, eine Alkenylgruppe, eine Arylgruppe oder eines der Substitutionsprodukte davon; und R⁴ bezeichnet jeweils eine Methylgruppe, eine Ethylgruppe, eine Propylgruppe, eine Isopropylgruppe oder eine Butylgruppe und die mehreren R⁴e können identisch miteinander oder unterschiedlich voneinander sein.)
R²R³Si(OR⁵) (2)
(R² und R³ bezeichnen jeweils ein Wasserstoffatom, eine Alkylgruppe, eine Alkenylgruppe, eine Arylgruppe oder eines der Substitutionsprodukte davon, und sie können identisch ohne oder unterschiedlich voneinander sein; und jedes R⁵ bezeichnet eine Methylgruppe, Ethylgruppe, Propylgruppe, Isopropylgruppe oder Butylgruppe und die mehreren R⁵e können identisch miteinander oder unterschiedlich voneinander sein.)
Si(OR⁶)₄ (3)
(jedes R⁶ bezeichnet eine Methylgruppe, eine Ethylgruppe, eine Propylgruppe, eine Isopropylgruppe oder eine Butylgruppe, und die mehreren R⁶e können identisch oder unterschiedlich voneinander sein.)

4. Siloxanharzzusammensetzung nach einem der Ansprüchen 1 bis 3, wobei die Siloxanverbindung eine organische Gruppe mit Fluoratomen enthält.

5. Siloxanharzzusammensetzung nach Anspruch 4, welche Fluoratome zu 10 Gew.-% oder mehr basierend auf dem Gesamtfeststoffgehalt enthält.

6. Gehärteter Film erhalten durch Härten der Siloxanharzzusammensetzung nach einem der Ansprüche 1 bis 5.

7. Gehärteter Film nach Anspruch 6, welcher einen Brechungsindex, welcher gemäß dem Verfahren, welches in der Beschreibung genannt wird, gemessen wird, von 1,45 oder weniger bei einer Wellenlänge von 632,8 nm aufweist.

8. Optischer Artikel mit dem gehärteten Film nach Anspruch 6.

9. Festes Bildgebungsgerät mit dem gehärteten Film nach Anspruch 6 auf Mikrolinsen.

10. Verfahren zum Herstellen der Siloxanharzzusammensetzung nach Anspruch 1 umfassend den Schritt des Kondensierens des Hydrolyseproduktes einer Alkoxysilanverbindung durch die Reaktion in Anwesenheit von 1-t-Butoxy-2-propanol, um die Siloxanverbindung zu erhalten.

## Revendications

1. Composition de résine de siloxane comprenant un composé de siloxane, le 1-t-butoxy-2-propanol et des particules de composé métallique, où la composition de résine de siloxane comprend en outre un agent photosensible à base de quinonediazide et est photosensible positive ou un agent de génération de photo-acide et est photosensible négative.

2. Composition de résine de siloxane selon la revendication 1, qui contient le composé de siloxane en une teneur supérieure ou égale à 10% en poids par rapport à la teneur totale en matières solides.

3. Composition de résine de siloxane selon la revendication 1 ou 2, dans laquelle le composé de siloxane comporte le produit d'hydrolyse et/ou le produit de condensation du ou des plusieurs composé(s) d'alcoxysilane choisi(s) parmi les formules générales (1) à (3) suivantes
R¹Si(OR⁴)₃ (1)
(R¹ désigne un atome d'hydrogène, un groupe alkyle, un groupe alcényle, un groupe aryle ou l'un des produits de substitution de ceux-ci ; et chaque R⁴ désigne un groupe méthyle, un groupe éthyle, un groupe propyle, un groupe isopropyle ou un groupe butyle, et la pluralité de R⁴ peuvent être identiques ou différents.)
R²R³Si(OR⁵) (2)
(R² et R³ désignent, respectivement, un atome d'hydrogène, un groupe alkyle, un groupe alcényle, un groupe aryle ou l'un des produits de substitution de ceux-ci, et ils peuvent être identiques ou différents ; et chaque R⁵ désigne un groupe méthyle, un groupe éthyle, un groupe propyle, un groupe isopropyle ou un groupe butyle, et la pluralité de R⁵ peuvent être identiques ou différents.)
Si(OR⁶)₄ (3)
(chaque R⁶ désigne un groupe méthyle, un groupe éthyle, un groupe propyle, un groupe isopropyle ou un groupe butyle, et la pluralité de R⁶ peuvent être identiques ou différents.)

4. Composition de résine de siloxane, selon l'une quelconque des revendications 1 à 3, dans laquelle le composé de siloxane contient un groupe organique avec des atomes de fluor.

5. Composition de résine de siloxane, selon la revendication 4, qui contient des atomes de fluor en une teneur supérieure ou égale à 10% en poids par rapport à la teneur totale en matières solides.

6. Film durci obtenu par durcissement de la composition de résine de siloxane telle que définie dans l'une quelconque des revendications 1 à 5.

7. Film durci selon la revendication 6, qui a un indice de réfraction mesuré selon le procédé mentionné dans la description, inférieur ou égal à 1,45 à une longueur d'onde de 632,8 nm.

8. Article optique ayant le film durci tel que défini dans la revendication 6.

9. Dispositif d'imagerie à semi-conducteurs ayant le film durci tel que défini dans la revendication 6 sur des microlentilles.

10. Procédé de production de la composition de résine de siloxane telle que définie dans la revendication 1, comprenant l'étape de condensation du produit d'hydrolyse d'un composé d'alcoxysilane par réaction en présence du 1-t-butoxy-2-propanol pour obtenir le composé de siloxane.
